(19) Europäisches Patentamt
European Patent Office
Office européen des brevets

(11) EP 4 700 403 A1

(12) EUROPEAN PATENT APPLICATION
published in accordance with Art. 153(4) EPC

(43) Date of publication:
25.02.2026 Bulletin 2026/09

(51) International Patent Classification (IPC):
G01R 31/367 (2019.01)       G01R 31/374 (2019.01)
G01R 31/3842 (2019.01)      G01R 31/396 (2019.01)
G01R 19/165 (2006.01)       G01R 19/10 (2006.01)
G01R 19/00 (2006.01)        G06N 20/00 (2019.01)
B60L 58/12 (2019.01)

(21) Application number: 24894417.5

(22) Date of filing: 29.10.2024

(52) Cooperative Patent Classification (CPC):
B60L 58/12; G01R 19/00; G01R 19/10;
G01R 19/165; G01R 31/367; G01R 31/374;
G01R 31/3842; G01R 31/396; G06N 20/00;
H01M 10/052; Y02E 60/10

(86) International application number:
PCT/KR2024/016662

(87) International publication number:
WO 2025/110523 (30.05.2025 Gazette 2025/22)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 24.11.2023  KR 20230165769
21.05.2024  KR 20240065906

(71) Applicant: LG Energy Solution, Ltd.
Seoul 07335 (KR)

(72) Inventors:
• YOON, Seo-Young
Daejeon 34122 (KR)
• CHOI, Soon-Hyung
Daejeon 34122 (KR)
• KIM, Young-Deok
Daejeon 34122 (KR)

(74) Representative: Goddar, Heinz J.
Boehmert & Boehmert
Anwaltspartnerschaft mbB
Pettenkoferstrasse 22
80336 München (DE)

(54) **BATTERY DIAGNOSIS METHOD AND BATTERY DIAGNOSIS APPARATUS**

(57) Provided is a battery diagnosis apparatus and a battery diagnosis method. The battery diagnosis method includes: obtaining diagnosis target information including a target full-cell profile of a battery cell associated with a first electric stimulation; correcting the target full-cell profile to be associated with a second electric stimulation that is different from the first electric stimulation, based on a predetermined overpotential profile; applying a diagnosis logic to the corrected target full-cell profile to determine first diagnosis result information, which is a preliminary diagnosis result for charge/discharge performance of the battery cell; and determining second diagnosis result information, which is a precise diagnosis result for the charge/discharge performance of the battery cell, based on at least one preliminary diagnosis factor included in the first diagnosis result information, using a factor correction model.

FIG. 1

**Description**

TECHNICAL FIELD

The present disclosure relates to a battery diagnosis apparatus and method for non-destructively diagnosing the charge/discharge performance of a battery.

The present application claims priority to Korean Patent Application No. 10-2023-0165769 filed on November 24, 2023, and Korean Patent Application No. 10-2024-0065906 filed on May 21, 2024, in the Republic of Korea, the disclosures of which are incorporated herein by reference.

BACKGROUND ART

Recently, there has been a rapid increase in the demand for portable electronic products such as laptop computers, video cameras and mobile phones, and with the extensive development of electric vehicles, accumulators for energy storage, robots and satellites, many studies are being made on high performance batteries that can be repeatedly recharged.

Currently, commercially available batteries include nickel-cadmium batteries, nickel-hydrogen batteries, nickel-zinc batteries, lithium batteries and the like, and among them, lithium batteries have little or no memory effect, and thus they are gaining more attention than nickel-based batteries for their advantages that recharging can be done whenever it is convenient, the self-discharge rate is very low and the energy density is high.

In general, the actual charge/discharge performance of a battery may fall short of the normal charge/discharge performance due to reasons such as manufacturing defects or deterioration due to use, and it is necessary to accurately diagnose the charge/discharge performance of the battery in order to improve the life and safety of the battery.

Conventionally, while a low electric stimulation (e.g., low-rate charge or discharge) is being applied to the battery, the voltage and capacity of the battery are measured and recorded, and a full-cell profile representing the correspondence between the voltage and capacity is generated based on the recorded measurement values to diagnose the state of the battery. However, since the capacity and voltage of the battery change slowly while a low electric stimulation (e.g., low-rate charge or discharge) is being applied, there is a limitation in that it takes a long time to diagnose the battery.

In terms of shortening the diagnosis time, high-level electric stimulation is naturally more advantageous than low-level electric stimulation. However, when high electric stimulation (e.g., high-rate charge or discharge) is being applied to the battery, the proportion of overpotential in the battery voltage may increase excessively. More specifically, as the current flowing through the battery is greater, the polarization phenomenon is generated more, and overpotential is caused by the polarization phenomenon. Since the voltage of the battery may be viewed as the sum of OCV (Open Circuit Voltage) and overpotential, as the level of electric stimulation applied to the battery is higher, the difference between the battery voltage and the actual OCV increases.

As the voltage of the battery is closer to the actual OCV, the charge/discharge performance of the battery may be diagnosed more accurately, so overpotential acts as a kind of noise that reduces the diagnostic accuracy. Therefore, the diagnosis result of charge/discharge performance based on the full-cell profile obtained using high electric stimulation may have a significant gap with the actual charge/discharge performance of the battery.

DISCLOSURE

Technical Problem

The present disclosure is designed to solve the problems of the related art, and therefore the present disclosure is directed to providing a battery diagnosis method and battery diagnosis apparatus that may simultaneously shorten the diagnosis time and secure diagnosis accuracy simultaneously by applying a high electric stimulation to a battery to obtaining charge/discharge information ('first target full-cell profile' of the claims) and removing noise caused by overpotential included in the obtained charge/discharge information using a machine learning-based factor correction model.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

Technical Solution

In one aspect of the present disclosure, there is provided a battery diagnosis method comprising: obtaining diagnosis target information including a target full-cell profile of a battery cell associated with a first electric stimulation;

correcting the target full-cell profile to be associated with a second electric stimulation that is different from the first electric stimulation, based on a predetermined overpotential profile; applying a diagnosis logic to the corrected target full-cell profile to determine first diagnosis result information, which is a preliminary diagnosis result for charge/discharge performance of the battery cell; and determining second diagnosis result information, which is a precise diagnosis result for the charge/discharge performance of the battery cell, based on at least one preliminary diagnosis factor included in the first diagnosis result information, using a factor correction model.

An instantaneous voltage change induced in the battery cell when the second electric stimulation is applied may be smaller than an instantaneous voltage change induced in the battery cell when the first electric stimulation is applied.

The first electric stimulation may be a charging current greater than or equal to a first current rate, and the second electric stimulation may be a charging current less than or equal to a second current rate, which is less than the first current rate.

The first electric stimulation may be a discharging current greater than or equal to a first current rate, and the second electric stimulation may be a discharging current less than or equal to a second current rate, which is less than the first current rate.

The overpotential profile may represent a difference between a first reference full-cell profile and a second reference full-cell profile. The first reference full-cell profile may be predetermined as a correspondence between a capacity factor and a voltage of a reference cell while the first electric stimulation is being applied. The second reference full-cell profile may be predetermined as a correspondence between the capacity factor and the voltage of the reference cell while the second electric stimulation is being applied.

The step of correcting the target full-cell profile may be to subtract the overpotential profile from the target full-cell profile to generate the corrected target full-cell profile.

The diagnosis target information may further include temperature information of the battery cell measured during an application period of the first electric stimulation. The temperature information may be input into the factor correction model together with the at least one preliminary diagnosis factor.

The diagnosis target information may further include impedance information of the battery cell measured during an application period of the first electric stimulation. The impedance information may be input into the factor correction model together with the at least one preliminary diagnosis factor.

The factor correction model may be a machine learning model completely trained by a training data set that includes a pair of first diagnosis result information and second diagnosis result information of each of a plurality of test cells with different charge/discharge performance.

The first diagnosis result information of each of the plurality of test cells may be obtained by applying the diagnosis logic to each of a plurality of corrected test full-cell profiles. The plurality of corrected test full-cell profiles may be obtained by individually correcting a plurality of first test full-cell profiles associated with the first electric stimulation based on the overpotential profile. The second diagnosis result information of each of the plurality of test cells may be obtained by applying the diagnosis logic to a plurality of second test full-cell profiles associated with the second electric stimulation.

The step of determining the second diagnosis result information may be performed under the condition that a performance indicator of the factor correction model is evaluated to be greater than or equal to a threshold value.

The battery diagnosis may further comprise: transmitting a message to a user device notifying that additional training for the factor correction model is required when the performance indicator of the factor correction model is evaluated to be less than the threshold value.

The second diagnosis result information may include at least one type of diagnosis factor among a positive electrode participation start point, a positive electrode participation end point, and a positive electrode scale factor related to charge/discharge performance of a positive electrode as a precise diagnosis factor of the battery cell.

The second diagnosis result information may include at least one type of diagnosis factor among a negative electrode participation start point, a negative electrode participation end point, and a negative electrode scale factor related to charge/discharge performance of a negative electrode of the battery cell as a precise diagnosis factor of the battery cell.

The second diagnosis result information may include at least one type of diagnosis factor among a positive electrode loading amount related to charge/discharge performance of a positive electrode of the battery cell, a negative electrode loading amount related to charge/discharge performance of a negative electrode of the battery cell, and an NP ratio related to the charge/discharge performance of both the positive electrode and the negative electrode of the battery cell, as a precise diagnosis factor of the battery cell.

In another aspect of the present disclosure, there is provided a battery diagnosis apparatus comprising: a data obtaining unit configured to obtain diagnosis target information including a target full-cell profile of a battery cell associated with a first electric stimulation; and a control circuit configured to correct the target full-cell profile to be associated with a second electric stimulation that is different from the first electric stimulation, based on a predetermined overpotential profile. The control circuit is configured to: apply a diagnosis logic to the corrected target full-cell profile to determine first diagnosis result information, which is a preliminary diagnosis result for charge/discharge performance of the battery cell, and determine second diagnosis result information, which is a precise diagnosis result for the charge/discharge performance of the battery cell, based on at least one preliminary diagnosis factor included in the first diagnosis result information, using a factor correction model.

The control circuit may be configured to subtract the overpotential profile from the target full-cell profile to generate the corrected target full-cell profile.

The factor correction model may be a machine learning model completely trained by a training data set that includes a pair of first diagnosis result information and second diagnosis result information of each of a plurality of test cells with different charge/discharge performance.

In still another aspect of the present disclosure, there is provided a battery pack comprising the battery diagnosis apparatus.

In still another aspect of the present disclosure, there is provided a battery system comprising the battery diagnosis apparatus.

Advantageous Effects

According to at least one of the embodiments of the present disclosure, even if the charge/discharge information of the battery cell to be diagnosed (the 'target full-cell profile' in the claims) is obtained by applying a high-level electric stimulation to the battery cell, the charge/discharge performance of the battery may be accurately diagnosed. Accordingly, the time required to diagnose the charge/discharge performance of the battery cell may be shortened compared to a diagnosis method using a low-level electric stimulation (e.g., low-rate charge or discharge).

In addition, according to at least one of the embodiments of the present disclosure, by correcting the charge/-discharge information so that an overpotential component caused by high electric stimulation is at least partially removed and then analyzing the corrected charge/discharge information ('corrected target full-cell profile' in the claims), the accuracy of diagnosis of the charge/discharge performance may be improved.

In addition, according to at least one of the embodiments of the present disclosure, by correcting preliminary diagnosis result information representing the charge/discharge performance determined from the corrected charge/-discharge information using a machine learning-based factor correction model, precise diagnosis result information having a high degree of consistency with the actual charge/discharge performance of the battery may be secured.

The effects of the present disclosure are not limited to the effects mentioned above, and these and other effects will be clearly understood by those skilled in the art from the appended claims.

DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.

FIG. 1 is a drawing exemplarily showing the configuration of a battery system according to the present disclosure.
FIG. 2 is a drawing referenced for explaining the relationship between an electric stimulation and a full-cell profile.
FIG. 3 is a drawing schematically showing an overpotential profile that may be obtained from a first reference full-cell profile and a second reference full-cell profile of FIG. 2.
FIG. 4 is a graph referenced for explaining the relationship between a first target full-cell profile, a corrected target full-cell profile, and a second target full-cell profile.
FIG. 5 is a graph referenced for explaining an example of each of the corrected target full-cell profile, the second reference full-cell profile, the reference positive electrode profile, and the reference negative electrode profile.
FIGS. 6 to 8 are drawings referenced for explaining an example of a procedure for generating a comparison full-cell profile according to a diagnosis logic.
FIGS. 9 to 11 are drawings referenced for explaining another example of the procedure for generating a comparison full-cell profile according to a diagnosis logic.
FIG. 12 is a drawing referenced for explaining the function of a factor correction model.
FIGS. 13 to 21 are drawings referenced for explaining a training data set provided for training the factor correction model.
FIG. 22 is a diagram showing an example of a neural network structure of the factor correction model of FIG. 12.
FIG. 23 is a diagram showing an example of a correlation coefficient between diagnosis factors that may be obtained through training the factor correction model.
FIG. 24 is a flowchart for schematically illustrating a battery diagnosis method according to another embodiment of the present disclosure.
FIG. 25 is a flowchart for schematically illustrating an additional battery diagnosis method related to the battery diagnosis method of FIG. 24.

FIG. 26 is a drawing referenced for explaining the method according to FIG. 25.

BEST MODE

Hereinafter, preferred embodiments of the present disclosure will be described in detail with reference to the accompanying drawings. Prior to the description, it should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

The terms including the ordinal number such as "first", "second" and the like, are used to distinguish one element from another among various elements, but not intended to limit the elements by the terms.

Unless the context clearly indicates otherwise, the terms "comprise" and "include" when used in this specification, specify the presence of stated elements, but do not preclude the presence or addition of one or more other elements. Additionally, the term "... unit" as used herein refers to a processing unit of at least one function or operation, and may be implemented by hardware and software either alone or in combination.

In addition, throughout the specification, it will be further understood that when an element is referred to as being "connected to" another element, it can be directly connected to the other element or intervening elements may be present.

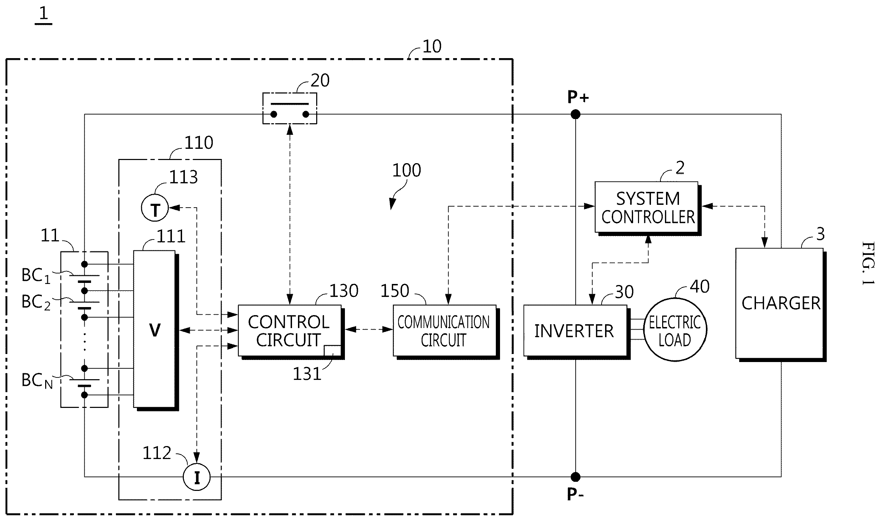

FIG. 1 is a drawing exemplarily showing the configuration of a battery system according to the present disclosure.

Referring to FIG. 1, the battery system 1 includes a system controller 2, a battery pack 10, a relay 20, an inverter 30, and an electric load 40.

Charging and discharging terminals P+ and P- of the battery pack 10 may be electrically connected to an inverter 30 and/or a charger 3 through a charging cable or the like. The charger 3 may be included in a battery system 1 or may be provided at a charging station.

The system controller 2 (e.g., ECU: Electronic Control Unit) is configured to transmit a key-on signal to the battery diagnosis apparatus 100 in response to that a start button (not shown) provided in the battery system 1 is switched to an ON position by a user. The system controller 2 is configured to transmit a key-off signal to the battery diagnosis apparatus 100 in response to that the start button is switched to an OFF position by the user. The charger 3 may communicate with the system controller 2 and supply a charging power in a constant current charging mode, a constant voltage charging mode and/or a constant power charging mode to the battery 11 through the charging and discharging terminals P+ and P- of the battery pack 10.

The battery pack 10 includes a battery 11. The battery pack 10 may further include the battery diagnosis apparatus 100.

The battery 11 includes at least one battery cell BC. When the battery 11 includes a plurality of battery cells ($BC_1$ to $BC_N$, N is a natural number greater than or equal to 2), the plurality of battery cells may be connected in series, in parallel, or in a mixture of series and parallel.

The type of the battery cell BC is not particularly limited, as long as it is capable of repeated charging and discharging, such as a lithium ion cell. The battery cell BC may include at least one unit cell. The unit cell is an electrochemical device that may be recharged independently. When the battery cell BC includes a plurality of unit cells, the plurality of unit cells may be connected in series, in parallel, or in a mixture of series and parallel. The battery cell BC may be a new battery cell that requires verification as to whether it is a good product, or a battery cell that has deteriorated after being verified as a good product and is no longer a new product. Hereinafter, the battery cell BC may be referred to as a 'target battery cell' or a 'target cell.'

The relay 20 is electrically connected in series to the battery 11 through a power path that connecting the battery 11 and the inverter 30. In FIG. 1, the relay 20 is illustrated as connected between the positive electrode terminal of the battery 11 and the charging and discharging terminal P+. The relay 20 is controlled to turn on and off in response to a switching signal from the battery diagnosis apparatus 100. The relay 20 may be a mechanical contactor turned on and off by the magnetic force of a coil, or a semiconductor switch such as a MOSFET (Metal Oxide Semiconductor Field Effect transistor).

The inverter 30 may convert DC current from the battery 11 into AC current in response to a command from the battery diagnosis apparatus 100 or the system controller 2.

The electric load 40 is driven using AC current power from the inverter 30. As the electric load 40, for example, a three-phase AC current motor 40 may be used.

The battery diagnosis apparatus 100 includes a control circuit 130 and a memory 131. The battery diagnosis apparatus 100 may further include at least one of a sensing unit 110 and a communication circuit 150. The 'data obtaining unit' recited in the claims of this application may refer to at least one of the sensing unit 110 and the communication circuit 150 or commonly call the sensing unit 110 and the communication circuit 150.

The sensing unit 110 includes a voltage sensor 111 and a current sensor 112.

The voltage sensor 111 is connected in parallel to the battery 11, measures the battery voltage, which is the voltage across both terminals of the battery 11, and is configured to generate a voltage signal representing the measured battery voltage.

Of course, the voltage sensor 111 may be connected to the positive electrode terminal and the negative electrode terminal of each battery cell BC included in the battery 11, measure the cell voltage (which may be referred to as the 'full-cell voltage') which is the voltage across both terminals of each battery cell BC, and output an additional voltage signal representing the measured cell voltage (i.e., a measurement value of the full-cell voltage) to the control circuit 130.

The current sensor 112 is connected in series to the battery 11 through a current path between the battery 11 and the inverter 30. The current sensor 112 is configured to detect the battery current, which is a current flowing through the battery 11, and generate a current signal representing the detected battery current. The current sensor 112 may be implemented as one or a combination of two or more of known current detection elements such as a shunt resistor, a Hall Effect element, etc.

The temperature sensor 113 is provided to measure the cell temperature, which is the temperature of the battery cell BC. The temperature sensor 113 may detect the cell temperature of the target cell BC periodically or aperiodically while the first electric stimulation is being applied to the battery cell BC. The temperature sensor 113 may generate a temperature signal representing the detected cell temperature.

The communication circuit 150 is configured to support wired or wireless communication between the control circuit 130 and the system controller 2. The wired communication may be, for example, CAN (Controller Area Network) communication, and the wireless communication may be, for example, ZigBee or Bluetooth communication. The type of communication protocol is not particularly limited as long as it supports wired and wireless communication between the control circuit 130 and the system controller 2. The communication circuit 150 may include an output device (e.g., a display, a speaker) that provides information received from the control circuit 130 and/or the system controller 2 in a form recognizable to the user.

The control circuit 130 is operably coupled to the relay 20, the voltage sensor 111, the current sensor 112 and the communication circuit 150. The operable coupling of two components means that the two components are connected directly or indirectly to enable transmission and reception of signals in one direction or two directions.

The control circuit 130 may collect the voltage signal from the voltage sensor 111 and/or the current signal from the current sensor 112. The control circuit 130 may convert each analog signal collected from the sensors 111 and 112 into a digital value using an ADC (Analog to Digital Converter) provided therein and record the digital value.

The control circuit 130 may be called a 'control unit' or a 'battery controller', and may be implemented in hardware using at least one of application specific integrated circuits (ASICs), digital signal processors (DSPs), digital signal processing devices (DSPDs), programmable logic devices (PLDs), field programmable gate arrays (FPGAs), microprocessors or electrical units for performing the other functions.

The memory 131 may include, for example, at least one type of storage medium of flash memory type, hard disk type, Solid State Disk (SSD) type, Silicon Disk Drive (SDD) type, multimedia card micro type, random access memory (RAM), static random access memory (SRAM), read-only memory (ROM), electrically erasable programmable read-only memory (EEPROM) or programmable read-only memory (PROM). The memory 131 may store data and programs required for calculation operations by the control circuit 130. The memory 131 may store data representing the result of a calculation operation performed by the control circuit 130. Although the memory 131 is depicted in FIG. 1 as being physically independent from the control circuit 130, the memory 131 may be embedded within the control circuit 130.

The control circuit 130 may turn on the relay 20 in response to a key-on signal. The control circuit 130 may turn off the relay 20 in response to a key-off signal. The key-on signal is a signal that requests switching from the rest mode to the charging or discharging mode. The key-off signal is a signal that induces switching from the cycle state to the resting state. Alternatively, the system controller 2 may be responsible for turning on/off the relay 20 instead of the control circuit 130.

If the relay 20 is turned on while the inverter 30 or the charger 3 is operating, the battery 11 enters the cycle state. Conversely, if the relay 20 is turned off or the inverter 30 and the charger 3 stops operating, the battery 11 enters the resting state.

The cycle state refers to a state in which the battery 11 is being charged/discharged, and the resting state refers to a state in which charging/discharging of the battery 11 is stopped. The fact that the battery 11 is in a cycle state or a resting state means that each battery cell BC included in the battery 11 is also in a cycle state or a resting state.

The control circuit 130 may determine a voltage detection value and a current detection value based on a voltage signal and a current signal while the battery cell BC is in a cycle state and/or a resting state, and then determine (estimate) a SOC (State Of Charge) of the battery cell BC based on the voltage detection value and/or the current detection value.

If the charger 3 is operating in a constant current charging mode, the current rate (also referred to as 'C-rate') of the charging current supplied to the battery cell BC is a known constant value. Thus, when estimating the SOC of the battery cell BC, the current value of the constant current output from the charger 3 may be used instead of the current detection value obtained using the current sensor 112.

SOC is the ratio of the remaining capacity to the fully charged capacity (maximum capacity) of the battery cell BC, and is usually processed in the range of 0 to 1 or 0 to 100%. Known methods such as ampere counting, OCV (Open Circuit Voltage)-SOC curve, and/or Kalman filter may be utilized to determine SOC.

The communication circuit 150 may obtain the first target full-cell profile (corresponding to the 'target full-cell profile' in the claims) associated with the first electric stimulation from a separate computing device provided externally (e.g., an electric vehicle 1) via wired communication and/or wireless communication. Alternatively, the sensing unit 110 may directly generate the first target full-cell profile of the target cell BC based on a measurement signal including a current signal and a voltage signal of the target cell BC, which is a battery cell to be diagnosed. Alternatively, the control circuit 130 may collect a measurement signal including a current signal and a voltage signal of the target cell BC from the sensing unit 110, and then generate the first target full-cell profile of the target cell BC based on the collected measurement signals. The measurement signal may further include a temperature signal.

The control circuit 130 may generate the first target full-cell profile of the target cell BC based on the collected measurement signals.

The first target full-cell profile may represent the correspondence between the capacity factor and the voltage of the target cell BC while the first electric stimulation is being applied to the target cell BC. The capacity factor may be the residual capacity or SOC (State Of Charge).

The first electric stimulation is an electric stimulation in which an instantaneous voltage change induced in the target cell BC when the first electric stimulation is applied exceeds an allowable level, and corresponds to a 'high electric stimulation'. The second electric stimulation is an electric stimulation in which an instantaneous voltage change induced in the target cell BC when the second electric stimulation is applied is less than the allowable level, and corresponds to a 'low electric stimulation'. For example, the first electric stimulation may be a charging current at a first current rate (e.g., 1.0C, 0.33C, etc.), and the second electric stimulation may be a charging current at a second current rate (e.g., 0.05C) less than the first current rate. For another example, the first electric stimulation may be a discharging current at the first current rate, and the second electric stimulation may be a discharging current at the second current rate.

The first target full-cell profile may be a profile representing the correspondence between the full-cell voltage and the capacity of the target cell BC while being charged or discharged at a constant current over a given voltage range (e.g., 3.0 to 4.0 V) or a given SOC range (e.g., 0 to 100% SOC).

The data obtaining unit may further obtain temperature information of the target cell BC during the application period of the first electric stimulation associated with the first target full-cell profile. The temperature information of the target cell BC includes at least one of a start temperature, an end temperature, an average temperature, a maximum temperature, and a minimum temperature. The start temperature represents a temperature at a start time point of the application period of the first electric stimulation. The end temperature represents a temperature at an end time point of the application period of the first electric stimulation. The average temperature represents an average temperature over the application period of the first electric stimulation. The maximum temperature represents a maximum temperature in the application period of the first electric stimulation. The minimum temperature represents a minimum temperature in the application period of the first electric stimulation.

Hereinafter, before explaining the first target full-cell profile obtained using the target cell BC of the present disclosure, the first reference full-cell profile and the second reference full-cell profile will be explained first.

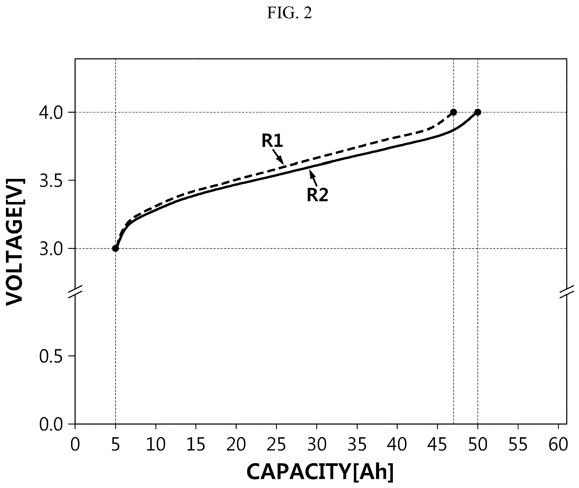

FIG. 2 is a drawing referenced for explaining the relationship between an electric stimulation and a full-cell profile.

The first reference full-cell profile R1 and the second reference full-cell profile R2 illustrated in FIG. 2 may be obtained in advance through a pre-experimental procedure of individually applying the first electric stimulation and the second electric stimulation to a reference battery cell.

The reference battery cell is a battery cell that has been verified as normal and may have the same level of positive electrode performance and negative electrode performance as a new battery cell that has been verified as a good product. The reference battery cell may be simply referred to as a 'reference cell'. The reference cell may be a coin-type cell that includes a positive electrode half-cell and a negative electrode half-cell, or a 3-electrode cell.

The new battery cell refers to a battery cell in a new state. The new state is the same concept as BOL (Beginning of Life). For example, it may be called BOL before the time when the cumulative charge/discharge capacity from the time of manufacturing completion reaches the set capacity, and it may be called MOL (Middle of Life) from the time when the cumulative charge/discharge capacity reaches the set capacity.

In the graph of FIG. 2, the horizontal axis (X-axis) represents capacity (Ah) and the vertical axis (Y-axis) represents voltage (V).

The first reference full-cell profile R1 illustrates the relationship between the capacity and voltage of the reference cell while the first electric stimulation is being applied (e.g., during charging using the first current rate). The second reference full-cell profile R2 illustrates the relationship between the capacity and voltage of the reference cell while the second electric stimulation is being applied (e.g., during charging using the second current rate). The first reference full-cell profile R1 may be obtained by performing charging using the first current rate in a state where the OCV of the reference cell is set equal to the lower limit (e.g., 3.0 V) of a given voltage range. The second reference full-cell profile R2 may be obtained by performing charging using the second current rate in a state where the OCV of the reference cell is set equal to the lower limit of a given voltage range. Therefore, in FIG. 2, the start points of the first reference full-cell profile R1 and the second reference full-cell profile R2 roughly coincide, whereas the end points are distinctly different.

The first reference full-cell profile R1 and the second reference full-cell profile R2 may represent the correspondence between the full-cell voltage and the capacity of the reference cell over at least the voltage range of interest (e.g., 3.0 to 4.0V). The lower and upper limits of the voltage range of interest may represent the first set voltage (3.0V in FIG. 2) and the second set voltage (4.0V in FIG. 2).

The SOC when the full-cell voltage of any battery cell is equal to the first set voltage may be set to 0%, and the SOC when the full-cell voltage is equal to the second set voltage may be set to 100%. That is, the first set voltage and the second set voltage may be lower and upper limits of the battery cell voltage corresponding to the SOC (State Of Charge) of 0% to 100% of any battery cell including the reference cell.

The start capacity (Qi) may refer to the residual capacity when the full-cell voltage of any battery cell is equal to the first set voltage. The end capacity (Qf) may refer to the residual capacity when the full-cell voltage of any battery cell is equal to the second set voltage.

The first reference full-cell profile R1 may be based on the voltage time series and current time series (or capacity time series) acquired by periodically measuring the full-cell voltage and current of the reference cell while the first electric stimulation is being applied.

The second reference full-cell profile R2 may be based on the voltage time series and current time series acquired by periodically measuring the full-cell voltage and current of the reference cell while the second electric stimulation is being applied.

Here, the first reference full-cell profile R1 may include overpotential in the voltage value corresponding to the same capacity value when compared with the second reference full-cell profile R2. Therefore, the voltage difference between the first reference full-cell profile R1 and the second reference full-cell profile R2 for the same capacity value may be calculated as overpotential.

Specifically, by removing the second reference full-cell profile R2 based on the second electric stimulation from the first reference full-cell profile R1 based on the first electric stimulation (calculating the voltage difference by capacity), an overpotential profile indicating overpotential by capacity may be generated.

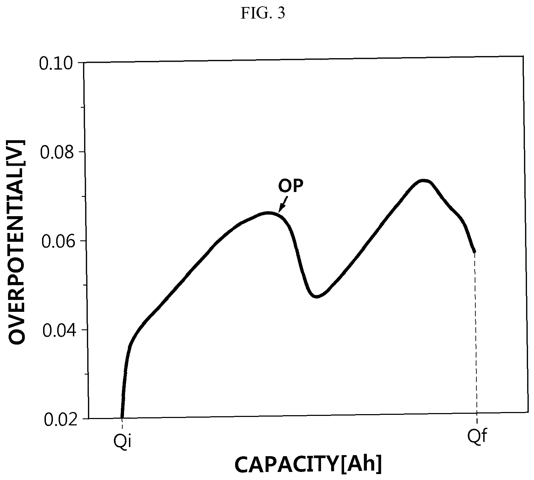

FIG. 3 is a drawing schematically showing an overpotential profile OP that may be obtained from a first reference full-cell profile R1 and a second reference full-cell profile R2 of FIG. 2.

The overpotential profile OP may be a profile representing the correspondence between capacity and overpotential. The overpotential profile OP may be a profile representing the voltage difference by capacity between the first reference full-cell profile R1 and the second reference full-cell profile R2.

The capacity range (Qi to Qf) of the overpotential profile OP may be a common capacity range between the first reference full-cell profile R1 and the second reference full-cell profile R2. In FIG. 2, the capacity range of the first reference full-cell profile R1 is 5 to 47 Ah, and the capacity range of the second reference full-cell profile R2 is 5 to 50 Ah, so Qi may be 5 Ah and Qf may be 47 Ah.

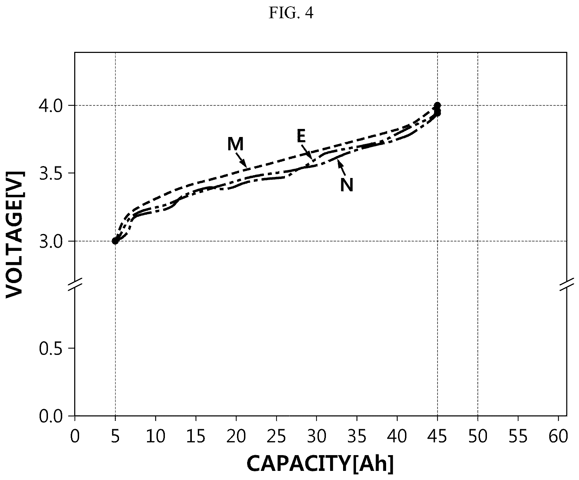

FIG. 4 is a graph referenced for explaining the relationship between a first target full-cell profile M, a corrected target full-cell profile E, and a second target full-cell profile N.

In FIGS. 2 to 4, Ah is used as the unit of the horizontal axis, but this unit may be expressed in other forms. For example, instead of Ah, a percentage % indicating SOC (State Of Charge) may be used as the unit of the horizontal axis.

Referring to FIG. 4, the control circuit 130 may generate a first target full-cell profile M representing a correspondence between the capacity and the full-cell voltage of the target cell BC while the first electric stimulation is being applied to the target cell BC. The first target full-cell profile M may represent a correspondence between the full-cell voltage and the capacity of the target cell BC at least over a voltage range of interest.

Therefore, since the reference cell and the target cell BC have different charge/discharge performances, there is inevitably some difference between the first target full-cell profile M and the first reference full-cell profile R1.

For example, in the same voltage range of interest (e.g., 3.0 to 4.0 V), the capacity range of the first reference full-cell profile R1 shown in FIG. 2 is 5 to 47 Ah, whereas the capacity range of the first target full-cell profile M is 5 to 45 Ah.

The control circuit 130 may generate a corrected target full-cell profile E by correcting the first target full-cell profile M to be associated with the second electric stimulation based on the overpotential profile OP. Specifically, the control circuit 130 may generate the corrected target full-cell profile E by subtracting the overpotential profile OP from the first target full-cell profile M. As a result, at the same capacity value, the voltage value of the corrected target full-cell profile E may be less than the voltage value of the first target full-cell profile M.

The control circuit 130 may obtain the corrected target full-cell profile E by subtracting the capacity-specific overpotential of the overpotential profile OP from the capacity-specific voltage of the first target full-cell profile M in the common capacity range of the first target full-cell profile M and the overpotential profile OP. In this case, the capacity range of 45 to 47 Ah among the entire capacity range of the overpotential profile OP may not be utilized. That is, the corrected target full-cell profile E may be obtained by removing the capacity-specific overpotential of the overpotential profile OP corresponding to the capacity-specific voltage of the first target full-cell profile M.

Alternatively, the control circuit 130 may generate an adjusted overpotential profile (not shown in the drawing) by scaling the overpotential profile OP along the horizontal axis so that the capacity range of the overpotential profile OP matches the capacity range of the first target full-cell profile M. Subsequently, the control circuit 130 may generate a corrected target full-cell profile E by subtracting the overpotential value of the adjusted overpotential profile from the voltage value of the first target full-cell profile M. That is, the corrected target full-cell profile E may be obtained by removing the capacity-specific overpotential of the adjusted overpotential profile from the capacity-specific voltage of the first target full-cell profile M.

The second target full-cell profile N is an example of a profile representing the correspondence between the capacity factor and voltage of the target cell BC that would be expected to be obtained instead of the first target full-cell profile M if the second electric stimulation was applied to the target cell BC instead of the first electric stimulation.

The corrected target full-cell profile E is the estimation result of the second target full-cell profile N based on the first target full-cell profile M and the overpotential profile OP.

Referring to FIG. 4, since the corrected target full-cell profile E is a profile obtained by subtracting the overpotential profile OP from the first target full-cell profile M, the corrected target full-cell profile E is more similar to the second target full-cell profile N than the first target full-cell profile M. Therefore, in diagnosing the charge/discharge performance of the target cell BC, it is advantageous in terms of diagnostic accuracy to utilize the corrected target full-cell profile E instead of the first target full-cell profile M.

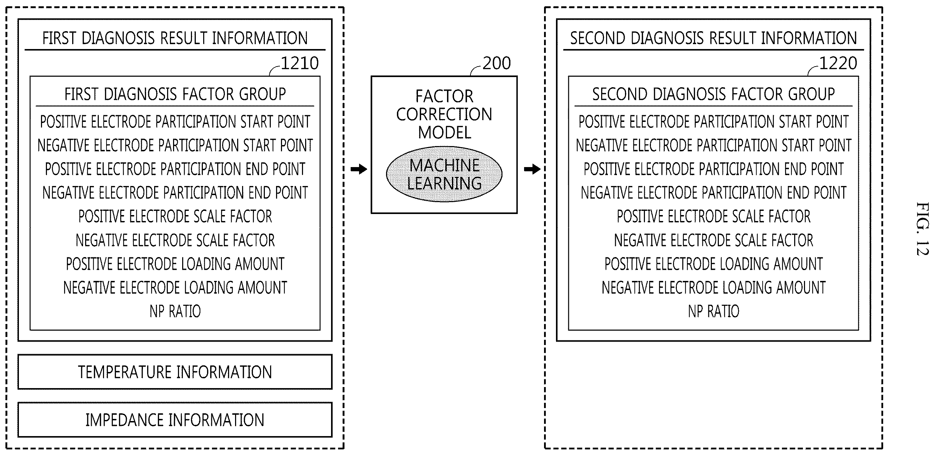

Meanwhile, since the corrected target full-cell profile E does not completely match the second target full-cell profile N, there may still be a considerable difference between the diagnosis result of charge/discharge performance based on the corrected target full-cell profile E and the actual charge/discharge performance. A method for reducing the error in the diagnosis result of charge/discharge performance will be described later with reference to FIG. 12.

The control circuit 130 may determine first diagnosis result information about the charge/discharge performance of the target cell BC by applying a diagnosis logic to the corrected target full-cell profile E. The first diagnosis result information may be regarded as a preliminary diagnosis result about the charge/discharge performance of the target cell BC. The first diagnosis result information may include a first diagnosis factor group, and the first diagnosis factor group may include at least one preliminary diagnosis factor.

The first diagnosis factor group may include at least one of a positive electrode participation start point, a positive electrode participation end point, a positive electrode scale factor, a negative electrode participation start point, a negative electrode participation end point, a negative electrode scale factor, a positive electrode loading amount, a negative electrode loading amount and an NP ratio as a preliminary diagnosis factor.

In this specification, the positive electrode participation start point on the positive electrode profile of any battery cell represents the positive electrode voltage and the positive electrode capacity (or positive electrode SOC) when the full-cell voltage of the corresponding battery cell matches the first set voltage. The positive electrode voltage at the positive electrode participation start point may be called the 'positive electrode start potential'. Also, the negative electrode participation start point on the negative electrode profile of the corresponding battery cell indicates the negative electrode voltage and the negative electrode capacity (or negative electrode SOC) when the full-cell voltage of the corresponding battery cell matches the first set voltage. The negative electrode voltage at the negative electrode participation start point may be called the 'negative electrode start potential'. Therefore, the voltage difference between the positive electrode participation start point and the negative electrode participation start point may be equal to the first set voltage.

In addition, the positive electrode participation end point on the positive electrode profile of any battery cell indicates the positive electrode voltage and the positive electrode capacity when the full-cell voltage of the corresponding battery cell matches the second set voltage. The positive electrode voltage at the positive electrode participation end point may be called the 'positive electrode end potential'. Also, the negative electrode participation end point on the negative electrode profile of the corresponding battery cell indicates the negative electrode voltage and the negative electrode capacity when the full-cell voltage of the corresponding battery cell matches the second set voltage. The negative electrode voltage at the negative electrode participation end point may be called the 'negative electrode end potential'. Therefore, the voltage difference between the positive electrode participation end point and the negative electrode participation end point may be equal to the second set voltage.

In this specification, the positive electrode capacity (capacity value) at a specific point on the positive electrode profile of any cell may mean the capacity difference between any one of both end points of the positive electrode profile and the specific point. The positive electrode SOC at a specific point on the positive electrode profile of any battery cell may mean the ratio of the capacity difference between any one of both end points (e.g., low capacity point) of the positive electrode profile and the specific point to the capacity difference between two end points of the positive electrode profile.

Likewise, the negative electrode capacity (capacity value) at a specific point on the negative electrode profile of any battery cell may mean the capacity difference between any one of both end points of the negative electrode profile (or positive electrode profile) and the specific point. The negative electrode SOC at a specific point on the negative electrode profile of any battery cell may mean the ratio of the capacity difference between any one of both end points (e.g., low capacity point) of the negative electrode profile (or positive electrode profile) and the specific point to the capacity difference between both end points of the negative electrode profile.

The positive electrode scale factor of any battery cell may represent the ratio of the capacity difference between the positive electrode participation start point and the positive electrode participation end point of the corresponding battery cell with respect to the reference positive electrode capacity of the reference cell. The negative electrode scale factor of any battery cell may represent the ratio of the capacity difference between the negative electrode participation start point and the negative electrode participation end point of the corresponding battery cell with respect to the reference negative electrode capacity of the reference cell.

In the memory 131, information indicating the voltage and capacity of each of the reference positive electrode participation start point, the reference positive electrode participation end point, the reference negative electrode participation start point, and the reference negative electrode participation end point, which represent the charge/-discharge performance of the reference cell, may be recorded in advance.

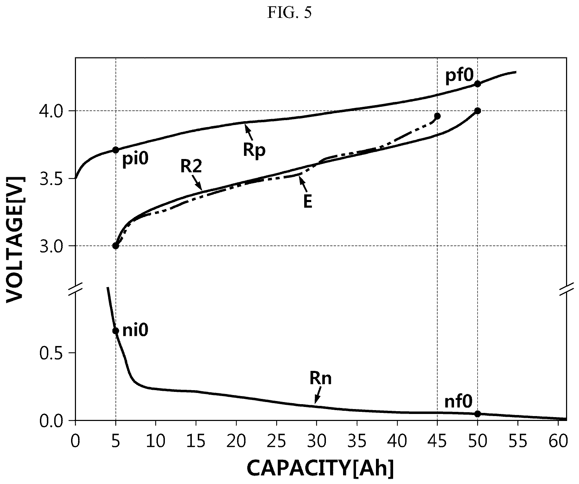

From now on, with reference to FIGS. 5 to 11, the diagnostic processes included in the diagnosis logic will be explained.

FIG. 5 is a graph referenced for explaining an example of each of the corrected target full-cell profile E, the second reference full-cell profile R2, the reference positive electrode profile Rp, and the reference negative electrode profile Rn. In the graph of FIG. 5, the horizontal axis (X-axis) represents capacity and the vertical axis (Y-axis) represents voltage. The corrected target full-cell profile E and the second reference full-cell profile R2 are the same as in FIG. 2.

Referring to FIG. 5, the reference positive electrode profile Rp may be a profile representing the correspondence between the positive electrode voltage and the capacity while the second electric stimulation is being applied to the reference cell. The positive electrode voltage of the reference cell refers to a potential difference between the potential of a reference electrode (not shown) and the potential of the positive electrode of the reference cell.

The reference negative electrode profile Rn may be a profile representing the correspondence between the negative electrode voltage and the capacity while the second electric stimulation is being applied to the reference cell. The negative electrode voltage of the reference cell refers to a potential difference between the potential of the reference electrode and the potential of the negative electrode of the reference cell.

The potential of the reference electrode may be, for example, the redox potential of lithium. The positive electrode voltage may be simply referred to as a positive electrode potential, and the negative electrode voltage can be simply referred to as a negative electrode potential.

The reference positive electrode profile Rp and the reference negative electrode profile Rn may be stored in advance in the memory 131.

At least one of the reference positive electrode profile Rp and the reference negative electrode profile Rn may be aligned along the horizontal axis so that the synthesis result of a part of the common capacity range (5 to 50 Ah in FIG. 5) of the reference positive electrode profile Rp and the reference negative electrode profile Rn matches the second reference full-cell profile R2.

FIG. 5 shows an example in which the reference negative electrode profile Rn is aligned to be shifted to the right based on the start point (point corresponding to capacity 0) of the reference positive electrode profile Rp.

It may be found from FIG. 5 that both ends of the reference positive electrode profile Rp and the reference negative electrode profile Rn are offset from each other. In other words, the capacity range of the reference positive electrode profile Rp and the capacity range of the reference negative electrode profile Rn do not match and may only partially overlap. Therefore, the second reference full-cell profile R2 may indicate the full-cell voltage of a reference cell in a part of the capacity range common to the reference positive electrode profile Rp and the reference negative electrode profile Rn.

The control circuit 130 may be configured to compare the corrected target full-cell profile E with at least one comparison full-cell profile. The comparison full-cell profile may be a result of generating an adjusted positive electrode profile and an adjusted negative electrode profile by adjusting each of the reference positive electrode profile Rp and the reference negative electrode profile Rn stored in the memory 131, and then synthesizing (combining) the adjusted positive electrode profile and the adjusted negative electrode profile.

In other words, when the second reference full-cell profile R2 is the result of subtracting a part of the reference negative electrode profile Rn from a part of the reference positive electrode profile Rp, the comparison full-cell profile may be regarded as the result of subtracting a part of the adjusted negative electrode profile from a part of the adjusted positive electrode profile.

The control circuit 130 may generate at least one comparison full-cell profile by directly adjusting the reference positive electrode profile Rp and the reference negative electrode profile Rn. Alternatively, the at least one comparison full-cell profile may be secured in advance based on the reference positive electrode profile Rp and the reference negative electrode profile Rn and stored in the memory 131. In this case, the control circuit 130 may obtain the comparison full-cell profile by accessing the memory 131 and reading the comparison full-cell profile.

The control circuit 130 may generate a plurality of comparison full-cell profiles from the reference positive electrode profile Rp and the reference negative electrode profile Rn by repeating an adjustment procedure of adjusting each of the reference positive electrode profile Rp and the reference negative electrode profile Rn to several levels and then synthesizing them. The comparison full-cell profile may also be referred to as an 'adjusted reference full-cell profile'.

The control circuit 130 may specify any one comparison full-cell profile among the plurality of comparison full-cell profiles, which has a minimum error with respect to the corrected target full-cell profile E. Then, the control circuit 130 may determine that the adjusted positive electrode profile and the adjusted negative electrode profile mapped to the specified comparison full-cell profile are the positive electrode profile and the negative electrode profile of the target cell BC.

In relation to this, various methods known at the time of filing of this application may be employed to determine the error between two profiles as a group of data points, each of which may be expressed in a two-dimensional coordinate system. For example, the integral or the RMSE (Root Mean Square Error) of the absolute value of the area between the two profiles may be used as the error between the two profiles.

According to this configuration of the present disclosure, various state information about the target cell BC may be obtained based on the finally determined adjusted positive electrode profile and adjusted negative electrode profile. The finally determined adjusted positive electrode profile and adjusted negative electrode profile may be mapped to any one comparison full-cell profile with the minimum error with respect to the corrected target full-cell profile E among the plurality of comparison full-cell profiles. In particular, the comparison full-cell profile obtained by the finally determined adjusted positive electrode profile and adjusted negative electrode profile may be almost identical to the corrected target full-cell profile E in shape, etc.

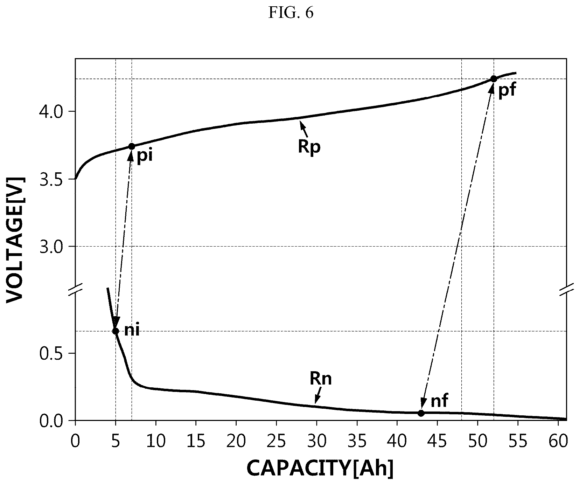

FIGS. 6 to 8 are diagrams referenced for explaining an example of a procedure for generating a comparison full-cell profile.

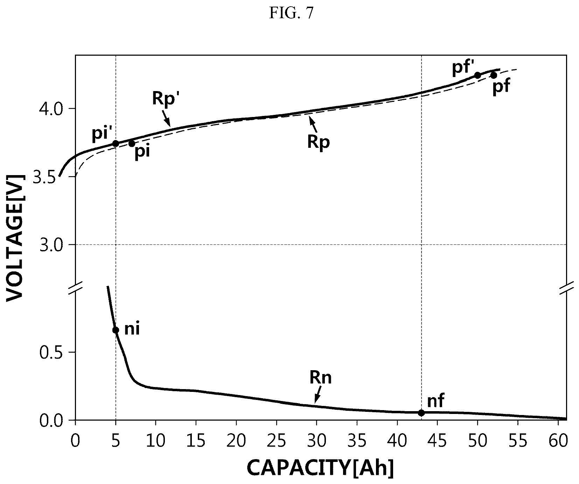

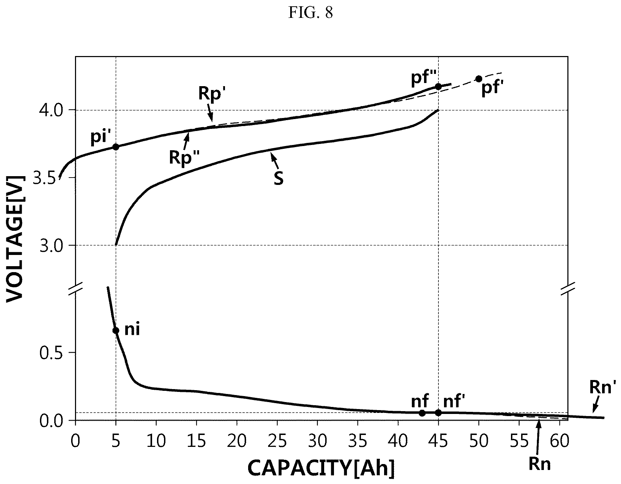

The procedure for generating a comparison full-cell profile, which will be explained with reference to FIGS. 6 to 8, may proceed in the order of a first routine for setting four points (positive electrode participation start point, positive electrode participation end point, negative electrode participation start point, negative electrode participation end point) to correspond to the voltage range of interest (see FIG. 6), a second routine for performing the profile shift (see FIG. 7), and a third routine for performing the capacity scaling (see FIG. 8). That is, the procedure for generating a comparison full-cell profile according to an embodiment of the present disclosure may include the first to third routines.

The reference positive electrode profile Rp and the reference negative electrode profile Rn shown in FIG. 6 are the same as those shown in FIG. 5.

The control circuit 130 may determine the positive electrode participation start point (pi), the positive electrode participation end point (pf), the negative electrode participation start point (ni) and the negative electrode participation end point (nf) on the reference positive electrode profile Rp and the reference negative electrode profile Rn.

Either the positive electrode participation start point (pi) or the negative electrode participation start point (ni) depends on the other.

As an example, the control circuit 130 may divide the positive electrode voltage range from the start point to the end point (or, second set voltage) of the reference positive electrode profile Rp into a plurality of small voltage sections, and then set a boundary point of two adjacent small voltage sections among the plurality of small voltage sections as a positive electrode participation start point (pi). Each small voltage section may have a predetermined size (e.g., 0.01V). Next, the control circuit 130 may set a point on the reference negative electrode profile Rn that is smaller than the positive electrode participation start point (pi) by the first set voltage (e.g., 3V) as a negative electrode participation start point (ni).

As another example, the control circuit 130 may divide the negative electrode voltage range from the start point to the end point of the reference negative electrode profile Rn into a plurality of small voltage sections of a predetermined size, and then set a boundary point of two adjacent small voltage sections among the plurality of small voltage sections as a negative electrode participation start point (ni). Next, the control circuit 130 may search for a point greater than the negative electrode participation start point (ni) by the first set voltage (e.g., 3V) from the reference positive electrode profile Rp and set the searched point as a positive electrode participation start point (pi).

Either the positive electrode participation end point (pf) or the negative electrode participation end point (nf) depends on the other.

As an example, the control circuit 130 may divide the voltage range from the second set voltage to the end point of the reference positive electrode profile Rp into a plurality of small voltage sections of a predetermined size, and then set a boundary point of two adjacent small voltage section among the plurality of small voltage sections as a positive electrode participation end point (pf). Next, the control circuit 130 may set a point on the reference negative electrode profile Rn that is smaller than the positive electrode participation end point (pf) by the second set voltage (e.g., 4V) as a negative electrode participation end point (nf).

As another example, the control circuit 130 may divide the negative electrode voltage range from the start point to the end point of the reference negative electrode profile Rn into plurality of small voltage sections of a predetermined size, and then set a boundary point between two adjacent small voltage sections among the plurality of small voltage sections as a negative electrode participation end point (nf). Next, the control circuit 130 may search for a point that is greater than the negative electrode participation end point (nf) by the second set voltage (e.g., 4V) from the reference positive electrode profile Rp and set the searched point as a positive electrode participation end point (pf).

If the positive electrode participation start point (pi), the positive electrode participation end point (pf), the negative electrode participation start point (ni), and the negative electrode participation end point (nf) are completely determined, the control circuit 130 shifts at least one of the reference positive electrode profile Rp and the reference negative electrode profile Rn to the left or right along the horizontal axis.

Referring to FIG. 6, the control circuit 130 may shift the reference positive electrode profile Rp to the left (toward low capacity) or shift the reference negative electrode profile Rn to the right (toward high capacity), or shift both of them, so that the capacity values of the positive electrode participation start point (pi) and the negative electrode participation start point (ni) match.

Alternatively, the control circuit 130 shifts the reference positive electrode profile Rp to the left or shift the reference negative electrode profile Rn to the right, or shift both of them, so that the capacity values of the positive electrode participation end point (pf) and the negative electrode participation end point (nf) match.

FIG. 7 illustrates a situation where only the reference positive electrode profile Rp is shifted to the left to generate an adjusted reference positive electrode profile (Rp'), and as a result, the capacity value of the positive electrode participation start point (pi') matches the capacity value of the negative electrode participation start point (ni). The adjusted reference positive electrode profile (Rp') may be the result of applying an adjustment procedure that shifts to the left by the capacity difference between the positive electrode participation start point (pi) and the negative electrode participation start point (ni) to the reference positive electrode profile Rp. Therefore, the two points (pi, pi') may be different only in capacity value and have the same voltage. Also, the two points (pf, pf') may be different only in the capacity value and have the same voltage.

If the adjustment result profiles (Rp', Rn) in which at least one of the reference positive electrode profile Rp and the reference negative electrode profile Rn is shifted are secured, the control circuit 130 may scale the capacity range of at least one of the adjustment result profiles (Rp', Rn).

According to the example shown in FIG. 7, the control circuit 130 may perform an additional adjustment procedure to shrink or expand at least one of the adjusted reference positive electrode profile (Rp') and the reference negative electrode profile Rn along the horizontal axis.

Referring to FIG. 8, the control circuit 130 may generate an adjusted reference positive electrode profile (Rp") by shrinking or expanding the adjusted reference positive electrode profile (Rp') so that the size of the capacity range between two points (pi', pf') of the adjusted reference positive electrode profile (Rp') matches the size of the capacity range of the corrected target full-cell profile E. At this time, any one point (pi') of the two points (pi', pf') may be fixed. Accordingly, the capacity difference between the two points (pi', pf") of the adjusted reference positive electrode profile (Rp") may match the capacity range of the corrected target full-cell profile E.

In addition, the control circuit 130 may generate an adjusted reference negative electrode profile (Rn') by shrinking or expanding the reference negative electrode profile Rn so that the size of the capacity range between two points (ni, nf) of the reference negative electrode profile Rn matches the size of the capacity range of the corrected target full-cell profile E. At this time, any one point (ni) of the two points (ni, nf) may be fixed. Accordingly, the capacity difference between the two points (ni, nf') of the adjusted reference negative electrode profile (Rn') may match the capacity range of the corrected target full-cell profile E.

In FIG. 8, the adjusted reference positive electrode profile (Rp") is the result of shrinking the adjusted reference positive electrode profile (Rp') shown in FIG. 7, and the adjusted reference negative electrode profile (Rn') is the result of expanding the reference negative electrode profile Rn shown in FIG. 7.

The positive electrode participation end point (pf") on the adjusted reference positive electrode profile (Rp") corresponds to the positive electrode participation end point (pf) on the adjusted reference positive electrode profile (Rp'). The negative electrode participation end point (nf') on the adjusted reference negative electrode profile (Rn') corresponds to the negative electrode participation end point (nf) on the reference negative electrode profile Rn.

The capacity difference between the positive electrode participation start point (pi') and the positive electrode participation end point (pf") of the adjusted reference positive electrode profile (Rp") corresponds to the size of the capacity range of the corrected target full-cell profile E. Likewise, the capacity difference between the negative electrode participation start point (ni) and the negative electrode participation end point (nf') of the adjusted reference negative electrode profile (Rn') corresponds to the size of the capacity range of the corrected target full-cell profile E.

In addition, the capacity range by the two points (pi', pf') of the adjusted reference positive electrode profile (Rp") matches the capacity range by the two points (ni, nf') of the adjusted reference negative electrode profile (Rn'). The control circuit 130 may generate a comparison full-cell profile S by subtracting the portion between two points (pi, pf') of the adjusted reference positive electrode profile (Rp") from the portion between two points (ni, nf') of the adjusted reference negative electrode profile (Rn').

The control circuit 130 may calculate an error (profile error) between the comparison value between the comparison full-cell profile S and the corrected target full-cell profile E.

The control circuit 130 may map at least two of the adjusted reference positive electrode profile (Rp"), the adjusted reference negative electrode profile (Rn'), the positive electrode participation start point (pi'), the positive electrode participation end point (pf'), the negative electrode participation start point (ni), the negative electrode participation end point (nf'), the positive electrode scale factor, the negative electrode scale factor, the comparison full-cell profile S, and the profile error with each other and record the same in the memory 131.

The positive electrode scale factor of the adjusted reference positive electrode profile (Rp") may represent a ratio of the capacity difference between the two points (pi', pf') to the capacity difference between the two points (pi0, pf0). Alternatively, the positive electrode scale factor of the adjusted reference positive electrode profile (Rp") may represent a ratio of the positive electrode capacity difference between the two points (pi', pf') to the positive electrode capacity difference between the two points (pi0, pf0). Alternatively, the positive electrode scale factor of the adjusted reference positive electrode profile (Rp") may represent a ratio of the positive electrode SOC difference between the two points (pi', pf") to the positive electrode SOC difference between the two points (pi0, pf0).

The negative electrode scale factor of the adjusted reference negative electrode profile (Rn') may represent a ratio of the capacity difference between the two points (ni, nf') to the capacity difference between the two points (ni0, nf0). Alternatively, the negative electrode scale factor of the adjusted reference negative electrode profile (Rn') may represent a ratio of the negative electrode capacity difference between the two points (ni, nf') to the negative electrode capacity difference between the two points (ni0, nf0). Alternatively, the negative electrode scale factor of the adjusted reference negative electrode profile (Rn') may represent a ratio of the negative electrode SOC difference between the two points (ni, nf') to the negative electrode SOC difference between the two points (ni0, nf0).

Hereinafter, ps may be used as a symbol indicating a positive electrode scale factor, and ns may be used as a symbol indicating a negative electrode scale factor.

Meanwhile, as described above, when the positive electrode voltage range of the reference positive electrode profile Rp is divided into a plurality of small voltage sections, the boundary point of two adjacent small voltage sections among the plurality of small voltage sections may be set as a positive electrode participation start point (pi).

For example, if the positive electrode voltage range of the reference positive electrode profile Rp is divided into 100 small voltage ranges, there may be 100 boundary points that can be set as the positive electrode participation start point (pi). Also, if the voltage range greater than or equal to the second set voltage in the reference positive electrode profile Rp is divided into 40 small voltage ranges, there may be 40 boundary points that can be set as the positive electrode participation end point (pf). In this case, at least 4,000 different comparison full-cell profiles may be generated.

Of course, it will be easily understood by those skilled in the art that as the size of the small voltage section decreases, the maximum number of comparison full-cell profiles that can be generated increases, and conversely, as the size of the small voltage section increases, the maximum number of comparison full-cell profiles that can be generated decreases.

The control circuit 130 may identify a minimum value among profile errors of the plurality of comparison full-cell profiles generated as described above, and then obtain the first diagnosis factor group, which is information mapped to the minimum profile error (e.g., at least one of a positive electrode participation start point, a positive electrode participation end point, a negative electrode participation start point, a negative electrode participation end point, a positive electrode scale factor, and a negative electrode scale factor), from the memory 131.

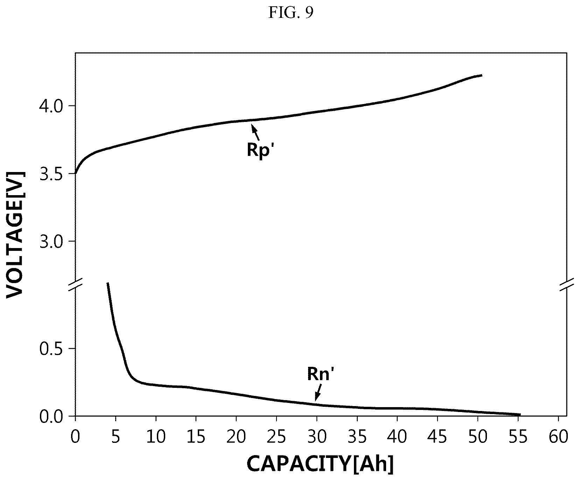

FIGS. 9 to 11 are diagrams referenced to describe another example of a procedure of generating a comparison full-cell profile according to the diagnosis logic. For reference, the embodiment shown in FIGS. 9 to 11 is independent from the embodiment shown in FIGS. 6 to 8. Accordingly, terms or reference signs commonly used to describe the embodiment shown in FIGS. 6 to 8 and the embodiment shown in FIGS. 9 to 11 should be understood as being limited to each embodiment.

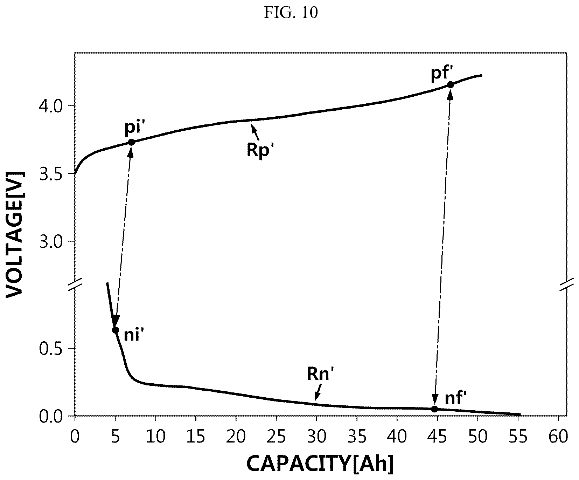

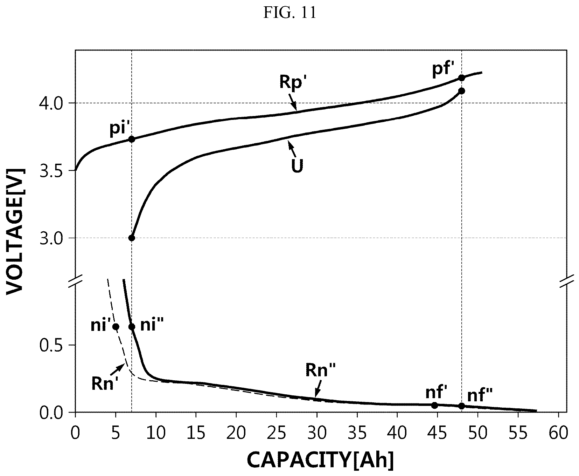

The procedure of generating a comparison full-cell profile U to be explained with reference to FIGS. 9 to 11 may proceed in the order of a fourth routine (see FIG. 9) that performs the capacity scaling, a fifth routine (see FIG. 10) that sets four points (positive electrode participation start point, positive electrode participation end point, negative electrode participation start point, and negative electrode participation end point), and a sixth routine (see FIG. 11) that performs the profile shift. That is, the procedure of generating a comparison full-cell profile according to another embodiment of the present disclosure may include the fourth to sixth routines.

Referring to FIG. 9, the control circuit 130 may generate an adjusted reference positive electrode profile (Rp') and an adjusted reference negative electrode profile (Rn') by applying the positive electrode scale factor and the negative electrode scale factor selected from the scaling value range to the reference positive electrode profile Rp and the reference negative electrode profile Rn, respectively.

The scaling value range may be predetermined or may vary depending on the ratio of the size of the capacity range of the corrected target full-cell profile E to the size of the capacity range of the second reference full-cell profile R2. As an example, assuming that the positive electrode scale factor and the negative electrode scale factor can be selected among the values (i.e., 90%, 90.1%, 90.2%, ... 98.9%, 99%) spaced by 0.1% in the scaling value range (e.g., 90 to 99%), 91 values may be selected as the positive electrode scale factor and the negative electrode scale factor, respectively. In this case, according to $91 \times 91 = 8,281$ adjustment levels (combinations of the positive electrode scale factors and the negative electrode scale factors), a maximum of 8,281 adjusted profile pairs (Rp', Rn') may be generated. The adjusted profile pair refers to a combination of an adjusted positive electrode profile (Rp') and an adjusted negative electrode profile (Rn').

Referring to FIG. 9, the adjusted reference positive electrode profile (Rp') and the adjusted reference negative electrode profile (Rn') illustrate the result of applying the positive electrode scale factor and the negative electrode scale factor, respectively, to the reference positive electrode profile Rp and the reference negative electrode profile Rn.

Since the positive electrode scale factor and the negative electrode scale factor are less than 100%, the adjusted reference positive electrode profile (Rp') is obtained by shrinking the reference positive electrode profile Rp along the horizontal axis, and the adjusted reference negative electrode profile (Rn') is also obtained by shrinking the reference negative electrode profile Rn along the horizontal axis. To facilitate understanding, the reference positive electrode profile Rp and the reference negative electrode profile Rn are shown in a form in which the start points of them are respectively fixed and the remaining parts are shrunken to the left along the horizontal axis.

Referring to FIG. 10, the control circuit 130 may determine a positive electrode participation start point (pi'), a positive electrode participation end point (pf'), a negative electrode participation start point (ni'), and a negative electrode participation end point (nf') on the adjusted reference positive electrode profile (Rp') and the adjusted reference negative electrode profile (Rp').

Either the positive electrode participation start point (pi') or the negative electrode participation start point (ni') may depend on the other. Also, either the positive electrode participation end point (pf') or the negative electrode participation end point (nf') may depend on the other. Also, either the positive electrode participation start point (pi') or the positive electrode participation end point (pf') may be set based on the other.

That is, if any one of the positive electrode participation start point (pi'), the positive electrode participation end point (pf'), the negative electrode participation start point (ni'), and the negative electrode participation end point (nf') is set, the remaining three points may be automatically set by the first set voltage, the second set voltage, and/or the size of the capacity range of the corrected target full-cell profile E (e.g., 45Ah - 5Ah = 40Ah in FIG. 4).

As an example, the control circuit 130 may divide the positive electrode voltage range from the start point to the end point (or, second set voltage) of the adjusted reference positive electrode profile (Rp') into a plurality of small voltage sections, and then set a boundary point of two adjacent small voltage sections among the plurality of small voltage sections as the positive electrode participation start point (pi'). Next, the control circuit 130 may set a point on the adjusted reference negative electrode profile (Rn') that is smaller than the positive electrode participation start point (pi') by the first set voltage as the negative electrode participation start point (ni').

As another example, the control circuit 130 may divide the negative electrode voltage range from the start point to the end point of the adjusted reference negative electrode profile (Rn') into a plurality of small voltage sections of a predetermined size, and then set a boundary point of two adjacent small voltage sections among the plurality of small voltage sections as the negative electrode participation start point (ni'). Next, the control circuit 130 may search for a point greater than the negative electrode participation start point (ni') by the first set voltage from the adjusted reference positive electrode profile (Rp'), and select the searched point as the positive electrode participation start point (pi').

As still another example, the control circuit 130 may divide the voltage range from the second set voltage to the end point of the adjusted reference positive electrode profile (Rp') into a plurality of small voltage sections of a predetermined size, and then set a boundary point of two adjacent small voltage sections among the plurality of small voltage sections as the positive electrode participation end point (pf'). Next, the control circuit 130 may search for a point smaller than the positive electrode participation end point (pf') by the second set voltage (e.g., 4V) from the adjusted reference negative electrode profile (Rn'), and set the searched point as the negative electrode participation end point (nf').

As still another example, the control circuit 130 may divide the negative electrode voltage range from the start point to the end point of the adjusted second reference negative electrode profile (Rn') into a plurality of small voltage section of a predetermined size, and then set a boundary point of two adjacent small voltage sections among the plurality of small voltage sections as the negative electrode participation end point (nf'). Next, the control circuit 130 may search for a point greater than the negative electrode participation end point (nf') by the second set voltage from the adjusted reference positive electrode profile (Rp'), and set the searched point as the positive electrode participation end point (pf').

If any one of the positive electrode participation start point (pi'), the positive electrode participation end point (pf'), the negative electrode participation start point (ni'), and the negative electrode participation end point (nf') is determined, the control circuit 130 may additionally determine the remaining three points based on the determined point.

For example, if the positive electrode participation start point (pi') is determined first, the control circuit 130 may set a point on the adjusted reference positive electrode profile (Rp') having a capacity value that is larger than the capacity value of the positive electrode participation start point (pi') by the size of the capacity range of the corrected target full-cell profile E as the positive electrode participation end point (pf'). In addition, the control circuit 130 may search for a point lower than the positive electrode participation start point (pi') by the first set voltage from the adjusted reference negative electrode profile (Rn'), and set the searched point as the negative electrode participation start point (ni'). In addition, the control circuit 130 may set a point on the adjusted reference negative electrode profile (Rn') having a capacity value greater than the capacity value of the negative electrode participation start point (ni') by the size of the capacity range of the corrected target full-cell profile E as the negative electrode participation end point (nf').

As another example, when the positive electrode participation end point (pf') is determined first, the control circuit 130 may set a point on the adjusted reference positive electrode profile (Rp') having a capacity value smaller than the capacity value of the positive electrode participation end point (pf') by the size of the capacity range of the corrected target full-cell profile E as the positive electrode participation start point (pi'). In addition, the control circuit 130 may search for a point lower than the positive electrode participation end point (pf') by the second set voltage from the adjusted reference negative electrode profile (Rn'), and set the searched point as the negative electrode participation end point (nf'). In addition, the control circuit 130 may set a point on the adjusted reference negative electrode profile (Rn') having a capacity value smaller than the capacity value of the negative electrode participation end point (nf') by the size of the capacity range of the corrected target full-cell profile E as the negative electrode participation start point (ni').

As still another example, when the negative electrode participation start point (ni') is determined, the control circuit 130 may set a point on the adjusted reference negative electrode profile (Rn') having a capacity value larger than the capacity value of the negative electrode participation start point (ni') by the size of the capacity range of the corrected target full-cell profile E as the negative electrode participation end point (nf'). In addition, the control circuit 130 may search for a point higher than the negative electrode participation start point (ni') by the first set voltage from the adjusted reference positive electrode profile (Rp'), and set the searched point as the positive electrode participation start point (pi'). In addition, the control circuit 130 may set a point on the adjusted reference positive electrode profile (Rp') having a capacity value greater than the capacity value of the positive electrode participation start point (pi') by the size of the capacity range of the corrected target full-cell profile E as the positive electrode participation end point (pf').

As still another example, when the negative electrode participation end point (nf') is determined, the control circuit 130 may set a point on the adjusted reference negative electrode profile (Rn') having a capacity value smaller than the capacity value of the negative electrode participation end point (nf') by the size of the capacity range of the corrected target full-cell profile E as the negative electrode participation start point (ni'). In addition, the control circuit 130 may search for a point higher than the negative electrode participation end point (nf') by the second set voltage from the adjusted reference positive electrode profile (Rp'), and set the searched point as the positive electrode participation end point (pf'). In addition, the control circuit 130 may set a point on the adjusted reference positive electrode profile (Rp') having a capacity value smaller than the capacity value of the positive electrode participation end point (pf') by the size of the capacity range of the corrected target full-cell profile E as the positive electrode participation start point (pi').

If the positive electrode participation start point (pi'), the positive electrode participation end point (pf'), the negative electrode participation start point (ni') and the negative electrode participation end point (nf') are completely determined based on the pair of positive electrode scale factor and negative electrode scale factor, the control circuit 130 may shift at least one of the adjusted reference positive electrode profile (Rp') and the adjusted reference negative electrode profile (Rn') to the left or right along the horizontal axis so that the capacity values of the positive electrode participation start point (pi') and the negative electrode participation start point (ni') match or the capacity values of the positive electrode participation end point (pf') and the negative electrode participation end point (nf') match.

The adjusted reference negative electrode profile (Rn") shown in FIG. 11 is obtained by shifting only the adjusted reference negative electrode profile (Rn') shown in FIG. 10 to the right. Accordingly, the capacity values of the positive electrode participation start point (pi') and the negative electrode participation start point (ni") match each other in the horizontal axis. Relatedly, the capacity difference between the positive electrode participation start point (pi') and the positive electrode participation end point (pf') is equal to the capacity difference between the negative electrode participation start point (ni') and the negative electrode participation end point (nf'). Therefore, if the capacity values of the positive electrode participation start point (pi') and the negative electrode participation start point (ni") match each other in the horizontal axis, the capacity values of the positive electrode participation end point (pf') and the negative electrode participation end point (nf') also match each other in the horizontal axis.

Referring to FIG. 11, the control circuit 130 may generate a comparison full-cell profile U by subtracting the partial profile between two points (pi', pf") of the adjusted reference positive electrode profile (Rp') from the partial profile between two points (ni", nf") of the adjusted reference negative electrode profile (Rn").

The control circuit 130 may calculate an error (profile error) between the comparison full-cell profile U and the corrected target full-cell profile E.

The control circuit 130 may map at least two of the adjusted reference positive electrode profile (Rp'), the adjusted reference negative electrode profile (Rn"), the positive electrode participation start point (pi'), the positive electrode participation end point (pf'), the negative electrode participation start point (ni"), the negative electrode participation end point (nf"), the positive electrode scale factor, the negative electrode scale factor, the comparison full-cell profile U and the profile error with each other and record the same in the memory 140.

As described above, the control circuit 130 may generate a comparison full-cell profile U corresponding to each pair of the positive electrode scale factor and the negative electrode scale factor selected from the scaling value range.

Since the pairs of positive electrode scale factor and negative electrode scale factor are plural, it is obvious that the comparison profile U will also be generated in plural numbers.

The control circuit 130 may identify a minimum value among profile errors of the plurality of comparison full-cell profiles, and then obtain information mapped to the minimum profile error from the memory 131.

As described above, the control circuit 130 may execute the diagnosis logic to generate a comparison full-cell profile with a minimum error from the corrected target full-cell profile E based on the reference positive electrode profile Rp and the reference negative electrode profile Rn.

The control circuit 130 may determine a first diagnosis factor group including at least one of a positive electrode participation start point, a positive electrode participation end point, a positive electrode scale factor, a negative electrode participation start point, a negative electrode participation end point, and a negative electrode scale factor, which are respectively mapped to a minimum profile error, as a preliminary diagnosis factor.

Meanwhile, since the first diagnosis factor group is the result of applying the diagnosis logic to the corrected target full-cell profile E, it may represents the actual charge/discharge performance of the target cell BC more accurately than the result of applying diagnosis logic to the first target full-cell profile M.

However, since the overpotential profile OP is related to the reference cell, not the target cell BC, there may still be a considerable difference between the charge/discharge performance indicated by the first diagnosis result information and the actual charge/discharge performance of the target cell BC.

Therefore, it is desirable to perform a procedure for correcting at least one preliminary diagnosis factor of the first diagnosis result information to narrow the gap between the charge/discharge performance indicated by the first diagnosis result information and the actual charge/discharge performance, and this may be achieved by a factor correction model, explained later. The correction procedure for the first diagnosis result information is performed to determine the second diagnosis result information as a precise diagnosis result for the charge/discharge performance of the target cell BC.

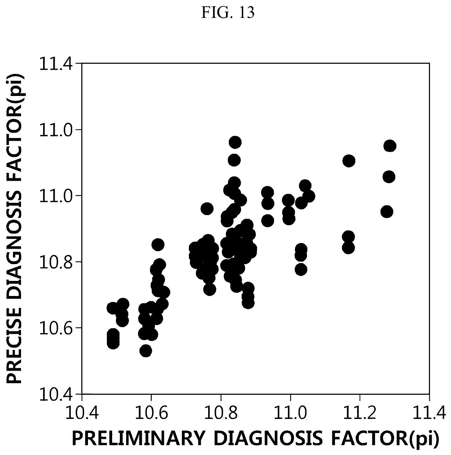

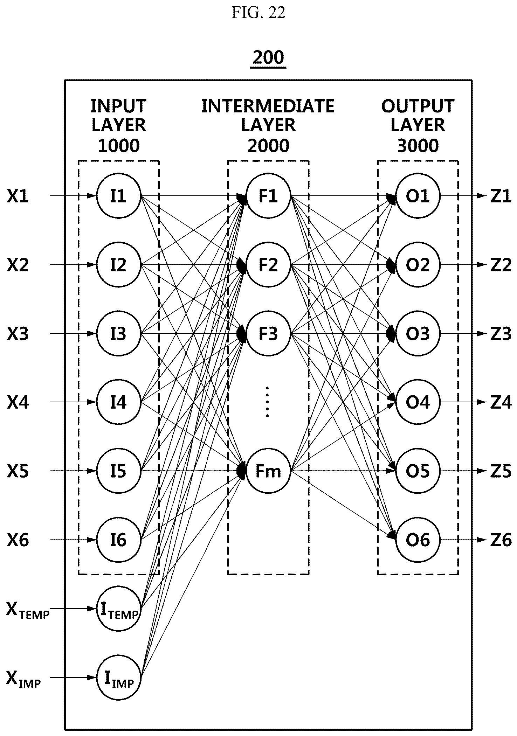

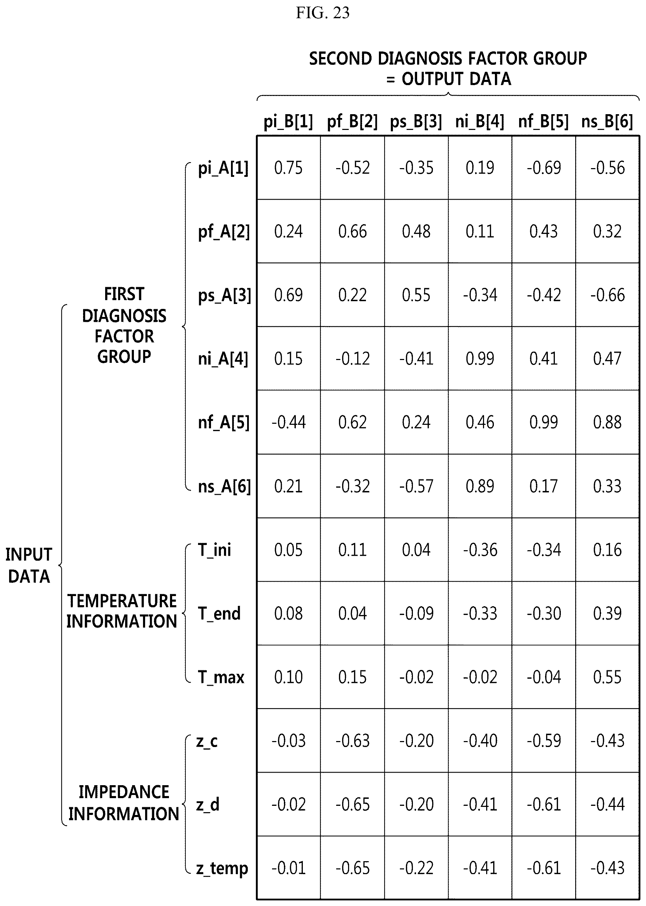

FIG. 12 is a drawing referenced for explaining the function of a factor correction model, FIGS. 13 to 21 are drawings referenced for explaining a training data set provided for training the factor correction model, FIG. 22 is a diagram showing an example of a neural network structure of the factor correction model of FIG. 12, and FIG. 23 is a diagram showing an example of a correlation coefficient between diagnosis factors that may be obtained through training the factor correction model.

Referring to FIG. 12, the control circuit 130 may determine second diagnosis result information as a precise diagnosis result for the charge/discharge performance of the target cell BC by applying the factor correction model 200 to at least one preliminary diagnosis factor of the first diagnosis factor group 1210, which is a preliminary diagnosis result for the charge/discharge performance of the target cell BC. The second diagnosis result information may include the second diagnosis factor group 1220, and the second diagnosis factor group 1220 may include at least one precise diagnosis factor.

The first diagnosis factor group 1210 may include at least one type of diagnosis factor among the positive electrode participation start point, the negative electrode participation start point, the positive electrode participation end point, the negative electrode participation end point, the positive electrode scale factor, the negative electrode scale factor, the positive electrode loading amount, the negative electrode loading amount, and the NP ratio of the target cell BC, which are determined based on the corrected target full-cell profile E, as a preliminary diagnosis factor.

The second diagnosis factor group 1220 may include at least one type of diagnosis factor among the positive electrode participation start point, the negative electrode participation start point, the positive electrode participation end point, the negative electrode participation end point, the positive electrode scale factor, the negative electrode scale factor, the positive electrode loading amount, the negative electrode loading amount, and the NP ratio of the target cell BC as a precise diagnosis factor.

At least one precise diagnosis factor of the second diagnosis factor group 1220 may be a result obtained by correcting at least one preliminary diagnosis factor of the first diagnosis factor group 1210 by the factor correction model 200 so that an error between the charge/discharge performance indicated by the first diagnosis factor group 1210 and the actual charge/discharge performance of the target cell BC is reduced. The second diagnosis factor group 1220 may represent an estimated result of the charge/discharge performance of the target cell BC that would have been determined if the diagnosis logic were applied to the second target full-cell profile N. For example, a specific diagnosis factor (e.g., the positive electrode participation start point) of the second diagnosis factor group 1220 may be the specific diagnosis factor of the first diagnosis factor group 1210 that is corrected to be close to the actual charge/discharge performance of the target cell BC.

The factor correction model 200 may be a machine learning model trained by a training data set including a pair of first diagnosis result information and second diagnosis result information of each of the plurality of test cells. The training data set may further include temperature information and/or impedance information of each of the plurality of test cells.

A plurality of test cells are prepared in advance for the purpose of training the factor correction model 200. At least one of the plurality of test cells may be a new battery cell verified as a good product. Each of the remaining test cells may have a test cell in which at least one of the positive electrode and the negative electrode is forcibly degraded from a new state by charge/discharge cycling different from that of the other test cells.

The first diagnosis result information of a specific test cell may include a first diagnosis factor group, which is obtained in advance by applying a diagnosis logic to the corrected test full-cell profile of the corresponding test cell. The corrected test full-cell profile of the specific test cell may be a first test full-cell profile of the corresponding test cell that is corrected based on the overpotential profile OP. The first test full-cell profile may represent a correspondence between a capacity factor and a voltage of the corresponding test cell while the first electric stimulation is being applied to the corresponding test cell. The first diagnosis factor group of the specific test cell may include at least one type of diagnosis factor among the positive electrode participation start point, the negative electrode participation start point, the positive electrode participation end point, the negative electrode participation end point, the positive electrode scale factor, and the negative electrode scale factor as a preliminary diagnosis factor of the specific test cell.

The temperature information of the specific test cell includes at least one of the start temperature, the end temperature, the average temperature, the maximum temperature, and the minimum temperature during the application period of the first electric stimulation for the corresponding test cell.

The second diagnosis result information of the specific test cell is obtained in advance by applying a diagnosis logic to the second test full-cell profile of the corresponding test cell, and may include a second diagnosis factor group. The second test full-cell profile of the specific test cell may represent a correspondence between the capacity factor and voltage of the corresponding test cell while the second electric stimulation is being applied to the corresponding test cell under a certain external environment. The second diagnosis factor group of the specific test cell may include at least one type of diagnosis factor among the positive electrode participation start point, the negative electrode participation start point, the positive electrode participation end point, the negative electrode participation end point, the positive electrode scale factor, the negative electrode scale factor, the positive electrode loading amount, the negative electrode loading amount, and the NP ratio as a precise diagnosis factor.

The graphs illustrated in FIGS. 13 to 21 are individually associated with nine types of diagnosis factors, and a plurality of data points representing a pair of the same type of diagnosis factors included in the training data set are marked on the two-dimensional coordinate. The number of data points marked in each graph may be equal to the number of test cells.

Each data point is defined by two estimated values of a diagnosis factor of a specific type. That is, the X-axis coordinate of each data point represents the value of the preliminary diagnosis factor included in the first diagnosis result information as an estimated value of the specific diagnosis factor, and the Y-axis coordinate represents the value of the precise diagnosis factor included in the second diagnosis result information as another estimated value of the specific diagnosis factor.

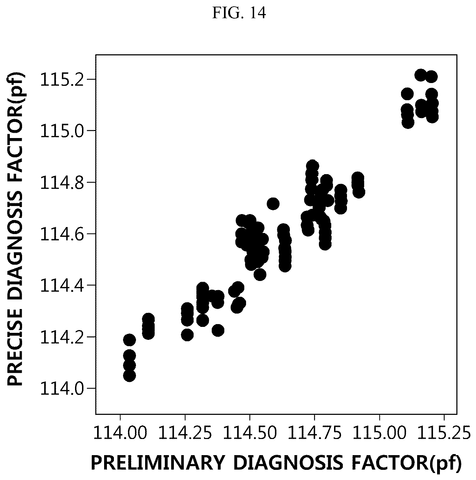

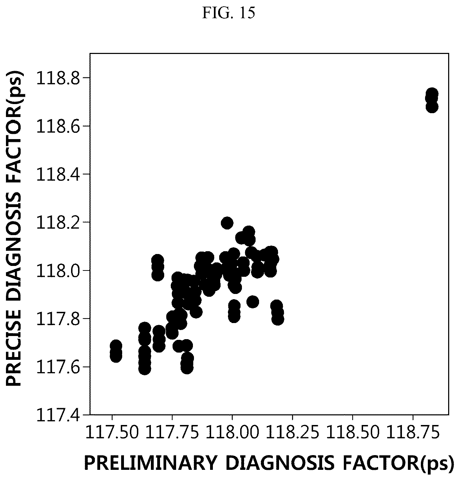

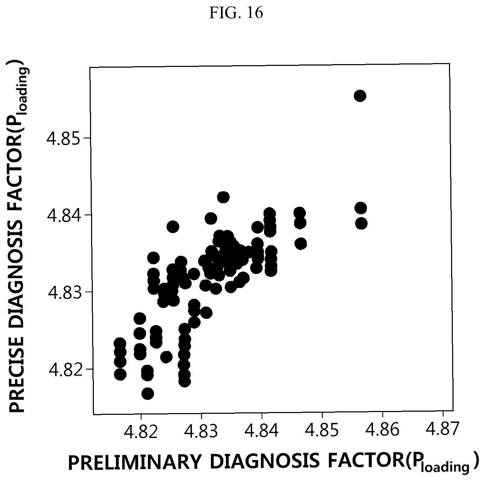

Each of the X-axis and the Y-axis of FIG. 13 is exemplarily illustrated as representing the positive electrode SOC of the positive electrode participation start point. Each of the X-axis and the Y-axis of FIG. 14 is exemplarily illustrated as representing the positive electrode SOC of the positive electrode participation end point. Each of the X-axis and the Y-axis of FIG. 15 is exemplarily illustrated as representing the positive electrode scale factor. Each of the X-axis and the Y-axis of FIG. 16 is exemplarily illustrated as representing the positive electrode loading amount. For reference, the positive electrode loading amount included in the first diagnosis factor group may be equal to the product of the positive electrode scale factor included in the first diagnosis factor group and the reference positive electrode loading amount.

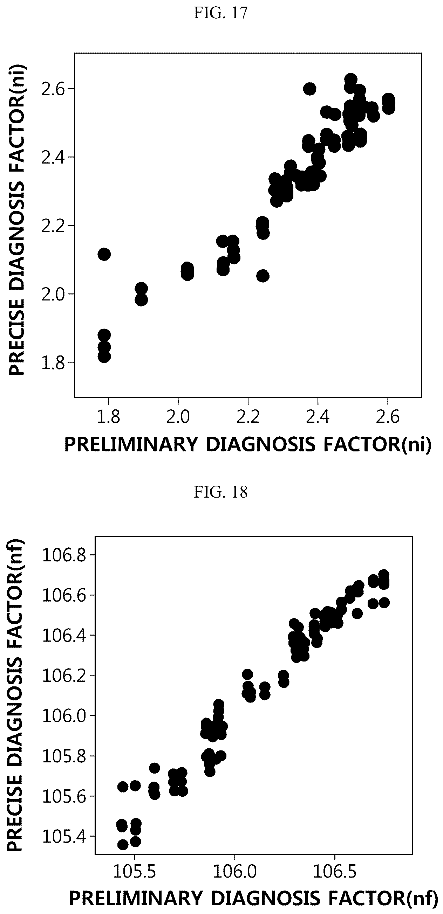

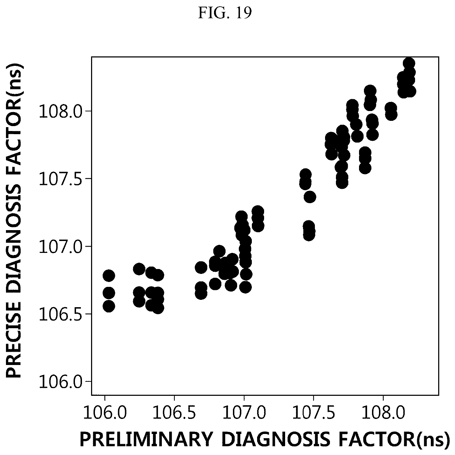

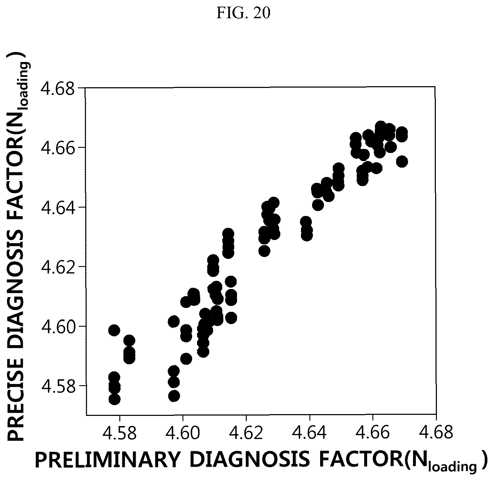

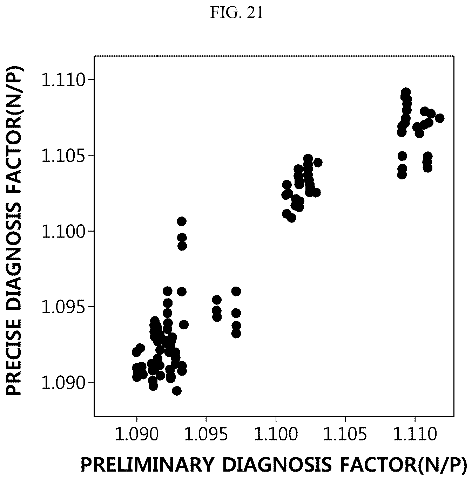

Each of the X-axis and the Y-axis of FIG. 17 is exemplarily illustrated as representing the negative electrode SOC of the negative electrode participation start point. Each of the X-axis and the Y-axis of FIG. 18 is exemplarily illustrated as representing the negative electrode SOC of the negative electrode participation end point. Each of the X-axis and the Y-axis of FIG. 19 is exemplarily illustrated as representing the negative electrode scale factor. Each of the X-axis and the Y-axis of FIG. 20 is exemplarily illustrated as representing the negative electrode loading amount. Each of the X-axis and the Y-axis of FIG. 21 is exemplarily illustrated as representing the NP ratio.

Referring to FIGS. 13 to 21, the data points of the training data set are distributed to have a trainable tendency. That is, the correlation between the value included in the first diagnosis result information and the value included in the second diagnosis result information as an estimated value of the diagnosis factor of each type may be trained by the factor correction model 200.

The factor correction model 200 may be trained based on the correlation between two estimated values for a specific diagnosis factor, and the correlation information between the two estimated values obtained through learning may be expressed as the correlation coefficient in FIG. 23. This will be explained in detail later.

Among the nine types of diagnosis factors described above, three types of diagnosis factors (i.e., the positive electrode loading amount, the negative electrode loading amount, and the NP ratio) may be regarded as being dependent on the remaining six diagnosis factors. Therefore, the following explanation will focus on the six diagnosis factors.

Referring to FIG. 22, the neural network of factor correction model 200 may include an input layer 1000, an intermediate layer 2000, and an output layer 3000.

In the factor correction model 200, the number of nodes included in each layer, the connections between nodes, the functions of each node included in the intermediate layer 2000, etc. may be determined in advance. In addition, the weights for each connection between nodes may be automatically determined through a machine learning process using the training data set.

The input layer 1000 may include first to sixth input nodes I1 to I6. The input layer 1000 may further include at least one additional input node ($I_{TEMP}$, $I_{IMP}$).

When i is a natural number less than or equal to 6, the $i^{th}$ input node Ii may be associated with one diagnosis factor of the first diagnosis factor group 1210. In FIG. 22, for convenience of explanation, it is assumed that the first to sixth input nodes I1 to I6 are associated with a positive electrode participation start point, a positive electrode participation end point, a positive electrode scale factor, a negative electrode participation start point, a negative electrode participation end point, and a negative electrode scale factor, which are six types of diagnosis factors that may be included in the first diagnosis factor group, respectively.

The $i^{th}$ input node Ii may be provided with the $i^{th}$ input data set Xi, which is diagnosis factor data associated therewith. For example, the first input node I1 may be provided with the first input data set X1. The first input data set X1 may include values (e.g., positive electrode start potential and capacity values) related to the positive electrode participation start points of the plurality of test cells.

The additional input node ($I_{TEMP}$) may be provided with an additional input data set ($X_{TEMP}$) associated therewith. The additional input data set ($X_{TEMP}$) may include a plurality of temperature information of the test cell (e.g., at least one of the start temperature, the end temperature, the average temperature, the maximum temperature, and the minimum temperature).

The additional input node ($I_{IMP}$) may be provided with an additional input data set ($X_{IMP}$) associated therewith. The additional input data set ($X_{IMP}$) may include impedance information of a plurality of test cells. The impedance information for each test cell may include at least one of the first to third impedances.

The first impedance may be the impedance at the high-rate charge as the first electric stimulation. The second impedance may be the impedance at the high-rate discharge as the first electric stimulation. The third impedance may be the result obtained by correcting the first impedance or the second impedance by the cell temperature. Each impedance may be the impedance at the start time point or the end time point of the application period of the first electric stimulation. Alternatively, each impedance may be the average impedance in the application period of the first electric stimulation.

For reference, it is common knowledge that the impedance of a battery cell is highly dependent on temperature. Therefore, the first impedance (or second impedance) may be corrected based on the temperature difference between the cell temperature measured at the same timing as the determination time of the first impedance (or second impedance) and the reference temperature. A predetermined relationship data between the correction amount for impedance and the temperature difference may be recorded in the memory. Meanwhile, it is widely known that the impedance of a battery cell may be determined using Ohm's law, EIS (electrochemical impedance spectroscopy), etc., and therefore will not be described in detail in this specification.

The output layer 3000 may include at least one of the first to sixth output nodes O1 to O6. When j is a natural number less than or equal to 6, the $j^{th}$ output node Oj may be associated with any one of a positive electrode participation start point, a positive electrode participation end point, a positive electrode scale factor, a negative electrode participation start point, a negative electrode participation end point, and a negative electrode scale factor. In FIG. 22, for convenience of explanation, it is assumed that the first to sixth output nodes O1 to O6 are associated with a positive electrode participation start point, a positive electrode participation end point, a positive electrode scale factor, a negative electrode participation start point, a negative electrode participation end point, and a negative electrode scale factor, respectively, which are six types of diagnosis factors. The positive electrode participation start point, the positive electrode participation end point, the positive electrode scale factor, the negative electrode participation start point, the negative electrode participation end point, and the negative electrode scale factor may be referred to as the first to sixth diagnosis factors, in that order.

When the input data sets (X1 to X6, $X_{TEMP}$, $X_{IMP}$) are input to the input nodes (I1 to I6, $I_{TEMP}$, $I_{IMP}$), the $j^{th}$ output data set Zj may be output from the $j^{th}$ output node Oj. For example, when the first output node O1 is associated with a positive electrode participation start point, the third output data set Z3 may include the correction results of the values of the first input data set X1.

FIG. 22 illustrates that the input layer 1000 includes the first to sixth input nodes I1 to I6 and the output input layer 2000 includes the first to sixth output nodes O1 to O6, but this is only an example. That is, the input layer 1000 may include at least one of the first to sixth input nodes I1 to I6, and the output layer 3000 may include at least one of the first to sixth output nodes O1 to O6. For example, when all of the input data sets (X1 to X6, $X_{TEMP}$, $X_{IMP}$) are provided to the input layer 1000, the output layer 3000 may output only one of the first to sixth output data sets Z1 to Z6.

Which output data set among the first to sixth output data sets Z1 to Z6 will be output by the factor correction model 200 may be determined by the connections between nodes, the weights for each connection between nodes, the functions of each node included in the intermediate layer 2000, etc., and is not particularly limited.

The intermediate layer 2000 may include first to $m^{th}$ intermediate nodes F1 to Fm (m is a natural number greater than or equal to 2). When k is a natural number less than or equal to m, the $k^{th}$ intermediate node Fk may be connected to at least one of the input nodes (I1 to I6, $I_{TEMP}$, $I_{IMP}$) and at least one of the first to sixth output nodes O1 to O6. The $k^{th}$

intermediate node Fk may have a form of a function determined through a learning process, and may transmit an estimated value calculated based on the input value from each input node connected thereto to each output node connected thereto. The $j^{th}$ output node Oj may output an estimated value equal to the sum of the estimated values received from each intermediate node connected thereto as a correction result of the first diagnosis factor group.

The function of the $k^{th}$ intermediate node Fk may be generated based on the correlation coefficient between the diagnosis factor associated with each node of the input layer 1000 connected to the $k^{th}$ intermediate node Fk and the diagnosis factor associated with each node of the output layer 3000 connected to the $k^{th}$ intermediate node Fk. For reference, the correlation coefficient is a real number between -1 and +1, and a correlation coefficient closer to -1 indicates a negative correlation between two factors, and a correlation coefficient closer to +1 indicates a positive correlation between two factors.

The function for each intermediate node of the intermediate layer 2000 may be a weighted average function. In this case, a correlation coefficient indicating the degree of correlation between the estimated values of the first to sixth diagnosis factors included in the first diagnosis factor group and the estimated values of at least one of the first to sixth diagnosis factors included in the second diagnosis factor group may be used as a weight of the function for each intermediate node of the intermediate layer 2000.

Therefore, the factor correction model 200 may include at least one of the first to sixth machine learning models. The first to sixth machine learning models may be models that provide precise diagnosis results for the first to sixth diagnosis factors, in that order.

When the target cell BC is in the MOL state, the control circuit 130 may determine at least one degradation parameter based on the second diagnosis factor group. Table 1 below summarizes the degradation parameters and formulas that may be used to determine each degradation parameter. For reference, the second diagnosis factor group when the target cell BC was in a new state may already be recorded in the memory 131.

Table 1

| Degradation parameter | Formula |
|---|---|
| $P_{SOH}$ | $1 - \dfrac{pf_{BOL} - pf_{MOL}}{pf_{BOL} - pi_{BOL}}$ , $\dfrac{pf_{MOL} - pi_{BOL}}{pf_{BOL} - pi_{BOL}}$, $1 - \dfrac{pf_{BOL} - pf_{MOL}}{nf_{BOL} - ni_{BOL}}$ , $\dfrac{ps_{MOL}}{ps_{BOL}}$ |
| $N_{SOH}$ | $\dfrac{ns_{MOL}}{ns_{BOL}}$ |
| $L_{SOH}$ | $1 - \dfrac{pi_{MOL} - pi_{BOL}}{pf_{BOL} - pi_{BOL}}$ , $\dfrac{pf_{BOL} - pi_{MOL}}{pf_{BOL} - pi_{BOL}}$, $1 - \dfrac{pi_{MOL} - pi_{BOL}}{nf_{BOL} - ni_{BOL}}$ |
| $F_{SOH}$ | $\dfrac{pf_{MOL} - pi_{MOL}}{pf_{BOL} - pi_{BOL}}$ , $\dfrac{nf_{MOL} - ni_{MOL}}{nf_{BOL} - ni_{BOL}}$ |
| $P_{LOSS}$ | $\dfrac{pf_{BOL} - pf_{MOL}}{pf_{BOL} - pi_{BOL}}$ , $\dfrac{pf_{BOL} - pf_{MOL}}{nf_{BOL} - ni_{BOL}}$ , $1 - \dfrac{ps_{MOL}}{ps_{BOL}}$ |
| $N_{LOSS}$ | $1 - \dfrac{ns_{MOL}}{ns_{BOL}}$ |
| $L_{LOSS}$ | $\dfrac{pi_{MOL} - pi_{BOL}}{pf_{BOL} - pi_{BOL}}$ , $\dfrac{pi_{MOL} - pi_{BOL}}{nf_{BOL} - ni_{BOL}}$ |
| $F_{LOSS}$ | $1 - \dfrac{pf_{MOL} - pi_{MOL}}{pf_{BOL} - pi_{BOL}}$, $1 - \dfrac{nf_{MOL} - ni_{MOL}}{nf_{BOL} - ni_{BOL}}$, $\dfrac{(pf_{BOL} - pi_{BOL}) - (pf_{MOL} - pi_{MOL})}{nf_{BOL} - ni_{BOL}}$ |
| $P_{loading\_MOL}$ | $ps_{MOL} \times P_{loading\_ref}$ |
| $N_{loading\_MOL}$ | $ns_{MOL} \times N_{loading\_ref}$ |

(continued)

| Degradation parameter | Formula |
|---|---|
| N/P$_{\_MOL}$ | $\dfrac{N_{\text{loading\_MOL}}}{P_{\text{loading\_MOL}}}, \quad \dfrac{ns_{\text{MOL}} \times Q_{N\_ref}}{ps_{\text{MOL}} \times Q_{P\_ref}}$ |

Each of the variables listed in Table 1 is a diagnostic factor that may be included in the second diagnosis factor group described above. The definitions of the degradation parameters and variables in Table 1 may be as follows.

<Degradation parameters >

$P_{SOH}$: positive electrode SOH (State Of Health) of the target cell BC
$N_{SOH}$: negative electrode SOH of the target cell BC
$L_{SOH}$: available lithium SOH of the target cell BC
$F_{SOH}$: full-cell SOH of the target cell BC
$P_{LOSS}$: positive electrode loss rate of the target cell BC
$N_{LOSS}$: negative electrode loss rate of the target cell BC
$L_{LOSS}$: available lithium loss rate of the target cell BC
$F_{LOSS}$: full-cell loss rate of the target cell BC
$P_{loading\_MOL}$: positive electrode loading amount of the target cell BC
$N_{loading\_MOL}$: negative electrode loading amount of the target cell BC
N/P$_{\_MOL}$ : NP ratio of the target cell BC

As any battery cell deteriorates, at least one of the total positive electrode capacity, the total negative electrode capacity, the available lithium content, and the total full-cell capacity of the battery cell may gradually decrease from the value at the BOL (Beginning Of Life) state. The total full-cell capacity may represent the capacity difference between both end points of the full-cell profile. For example, the total full-cell capacity may mean a full charge capacity (FCC). The available lithium content may represent the total amount of lithium that may contribute to charging and discharging of the battery cell. $P_{SOH}$ may represent the maintenance rate of the total positive electrode capacity. $N_{SOH}$ may represent the maintenance rate of the total negative electrode capacity. $L_{SOH}$ may represent the maintenance rate of the available lithium content. $F_{SOH}$ may represent the maintenance rate of the total full-cell capacity.

The sum of $P_{SOH}$ and $P_{LOSS}$, the sum of $N_{SOH}$ and $N_{LOSS}$, the sum of $L_{SOH}$ and $L_{LOSS}$, and the sum of $F_{SOH}$ and $F_{LOSS}$ may each be equal to 1. $F_{LOSS}$ may be equal to the sum of $P_{LOSS}$ and $L_{LOSS}$.

The positive electrode loading amount of any battery cell represents the amount of positive electrode active material (or available capacity) per unit area of the positive electrode of the battery cell. The negative electrode loading amount of any battery cell represents the amount of negative electrode active material (or available capacity) per unit area of the negative electrode of the battery cell. The unit of the loading amount may be mAh/cm$^2$ or mg/cm$^2$. In Table 1, $P_{loading\_ref}$ represents the reference positive electrode loading amount, and $N_{loading\_ref}$ represents the reference negative electrode loading amount.

The reference positive electrode loading amount is a predetermined value representing the amount of positive electrode active material (or available capacity) per unit area of the positive electrode of the reference cell. The reference positive electrode loading amount may be a value obtained by dividing the reference positive electrode capacity ($Q_{P\_ref}$) by the reference positive electrode area. Here, the reference positive electrode capacity may be a value preset as the total positive electrode capacity of the reference cell. The reference positive electrode area may be a value preset as the area of the positive electrode of the reference cell.

The reference negative electrode loading amount is a predetermined value representing the amount of negative electrode active material (or available capacity) per unit area of the negative electrode of the reference cell. The reference negative electrode loading amount may be a value obtained by dividing the reference negative electrode capacity ($Q_{N\_ref}$) by the reference negative electrode area. Here, the reference negative electrode capacity may be a value preset as the total negative electrode capacity of the reference cell. The reference negative electrode area may be a value preset as the area of the negative electrode of the reference cell.

At least one of the degradation parameters in Table 1 may be included in the second diagnosis factor group as an estimation result for an additional diagnosis factor of the target cell BC.

<Variables>

$pi_{BOL}$: positive electrode capacity (positive electrode SOC) of the positive electrode participation start point when the target cell BC is in the BOL state

$pi_{MOL}$: positive electrode capacity (positive electrode SOC) of the current positive electrode participation start point (e.g., pi' shown in FIG. 8) of the target cell BC

$pf_{BOL}$: positive electrode capacity (positive electrode SOC) of the positive electrode participation end point when the target cell BC is in the BOL state

$pf_{MOL}$: positive electrode capacity (positive electrode SOC) of the current positive electrode participation end point (e.g., pf" shown in FIG. 8) of the target cell BC

$ni_{BOL}$: negative electrode capacity (negative electrode SOC) at the negative electrode participation start point when the target cell BC is in the BOL state

$ni_{MOL}$: negative electrode capacity (negative electrode SOC) of the current negative electrode participation start point (e.g., ni shown in FIG. 8) of the target cell BC

$nf_{BOL}$: negative electrode capacity (negative electrode SOC) of the negative electrode participation end point when the target cell BC is in the BOL state

$nf_{MOL}$: negative electrode capacity (negative electrode SOC) of the current negative electrode participation end point (e.g., nf' shown in FIG. 8) of the target cell BC

$ps_{BOL}$: positive electrode scale factor when the target cell BC is in the BOL state

$ps_{MOL}$: current positive electrode scale factor of the target cell BC

$ns_{BOL}$: negative electrode scale factor when the target cell BC is in the BOL state

$ns_{MOL}$: current negative electrode scale factor of the target cell BC

The NP ratio may also be expressed as N/P ratio, N:P ratio, etc. The NP ratio of the target cell BC may be a value representing (i) the ratio of the negative electrode loading amount ($N_{loading\_MOL}$) to the positive electrode loading amount ($P_{loading\_MOL}$) of the target cell BC or (ii) the ratio of the total negative electrode capacity to the total positive electrode capacity of the target cell BC. The control circuit 130 may determine the total positive electrode capacity of the target cell BC as equal to the product of $ps_{MOL}$ and $Q_{P\_ref}$. The control circuit 130 may determine the total positive electrode capacity of the target cell BC as equal to the product of $ns_{MOL}$ and $Q_{N\_ref}$.

The process of determining the second diagnosis factor group may be repeated periodically or aperiodically throughout the life of the target cell BC.

FIG. 23 shows an example of correlation information between the first diagnosis factor group and the second diagnosis factor group obtained through learning for the factor correction model 200 in a matrix form.

Referring to FIG. 23, the first to sixth rows represent the first to sixth diagnosis factors of the first diagnosis factor group provided as the training data set in order. The six columns represent the first to sixth diagnosis factors of the second diagnosis factor group provided as the training data set in order. FIG. 23 exemplarily illustrates that the seventh to ninth rows correspond to the start temperature (T_ini), the end temperature (T_end), and the maximum temperature (T_max) included in the temperature information, and the tenth to twelfth rows correspond to the first impedance (z_c), the second impedance (z_d), and the third impedance (z_temp) included in the impedance information.

In FIG. 23, pi_A[1], pf_A[2], ps_A[3], ni_A[4], nf_A[5], and ns_A[6] represent the positive electrode participation start point, the positive electrode participation end point, the positive electrode scale factor, the negative electrode participation start point, the negative electrode participation end point, and the negative electrode scale factor, which are six types of preliminary diagnosis factors included in the first diagnosis factor group of the training data set, in that order. Also, pi_B[1], pf_B[2], ps_B[3], ni_B[4], nf_B[5] and ns_B[6] represent the positive electrode participation start point, the positive electrode participation end point, the positive electrode scale factor, the negative electrode participation start point, the negative electrode participation end point and the negative electrode scale factor, which are six types of precise diagnosis factors included in the second diagnosis factor group of the training data set, respectively.

When p and q are natural numbers less than or equal to 6, the values of the $p^{th}$ row (pi_A[p]) and the $q^{th}$ column (pi_B[q]) represent the correlation coefficient between the $p^{th}$ diagnosis factor included in the first diagnosis factor group and the $q^{th}$ diagnosis factor included in the second diagnosis factor group.

For example, the correlation coefficient between the first diagnosis factor (pi_A[1]) in the first row and the second diagnosis factor (pf_B[2]) in the second column is -0.52. As another example, the correlation coefficient between the fifth diagnosis factor (nf_A[5]) in the fifth row and the fourth diagnosis factor (ni_B[4]) in the fourth column is 0.46.

The value in the $7^{th}$ row and the $q^{th}$ column represents the correlation coefficient between the start temperature (T_ini) and the $q^{th}$ diagnosis factor. The value in the $8^{th}$ row and the $q^{th}$ column represents the correlation coefficient between the end temperature (T_end) and the $q^{th}$ diagnosis factor. The value in the $9^{th}$ row and the $q^{th}$ column represents the correlation coefficient between the maximum temperature (T_max) and the q$^{th}$ diagnosis factor.

The value in the 10$^{th}$ row and the q$^{th}$ column represents the correlation coefficient between the first impedance (z_c) and the q$^{th}$ diagnosis factor. The value in the 11$^{th}$ row and the q$^{th}$ column represents the correlation coefficient between the second impedance (z_d) and the q$^{th}$ diagnosis factor. The value in the 12$^{th}$ row and the q$^{th}$ column represents the correlation coefficient between the third impedance (z_temp) and the q$^{th}$ diagnosis factor.

Meanwhile, FIG. 23 relates to six types of diagnosis factors, but the present disclosure is not limited thereto. For example, the second diagnosis factor group of the training data set may further include three types of precise diagnosis factors corresponding to the positive electrode loading amount, the negative electrode loading amount, and the NP ratio. In this case, the correlation information between the first diagnosis factor group and the second diagnosis factor group may be expressed as a $6 \times 9$ matrix.

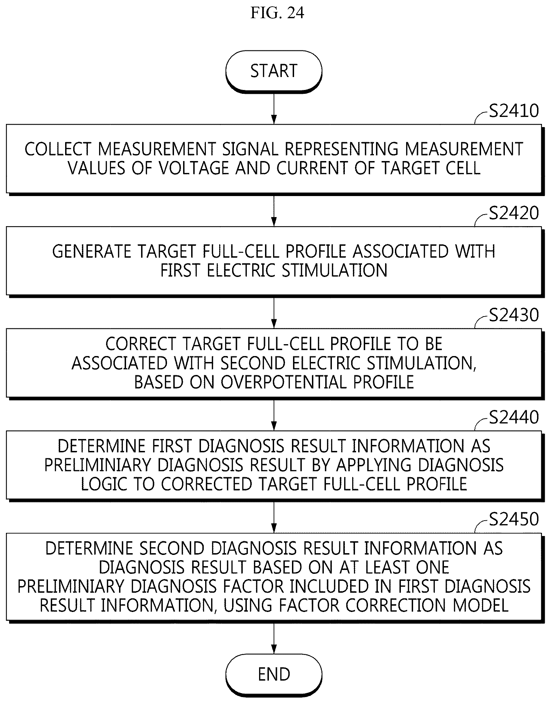

FIG. 24 is a flowchart for schematically illustrating a battery diagnosis method according to another embodiment of the present disclosure. The method of FIG. 24 may be executed by the battery diagnosis apparatus 100.

Referring to FIGS. 1 to 24, in Step S2410, the control circuit 130 collects, from the sensing unit 110, a measurement signal representing a measurement value of voltage and current of the target cell BC during the application period of the first electric stimulation to the target cell BC. The measurement signal may further represent a temperature of the target cell BC during the application period of the first electric stimulation.

In Step S2420, the control circuit 130 generates a target full-cell profile M associated with the first electric stimulation based on the measurement signal collected in Step S2410. The target full-cell profile M may represent a correspondence between the capacity factor and the voltage of the target cell BC while the first electric stimulation is being applied. In Step S2420, at least one of temperature information and impedance information of the target cell BC may be further generated. In this specification, the diagnosis target information may include the target full-cell profile M and may further include at least one of temperature information and impedance information.

Steps S2410 and S2420 may be replaced with a procedure in which the data obtaining unit obtains diagnosis target information directly or from the outside.

In Step S2430, the control circuit 130 corrects the target full-cell profile M to be associated with the second electric stimulation based on the overpotential profile OP. As a result, a corrected target full-cell profile E is generated.

In Step S2440, the control circuit 130 applies a diagnosis logic (see FIGS. 4 to 11) to the corrected target full-cell profile E to determine first diagnosis result information as a preliminary diagnosis result for the charge/discharge performance of the target cell BC.

In Step S2450, the control circuit 130 determines second diagnosis result information as a precise diagnosis result for the charge/discharge performance of the target cell BC based on at least one preliminary diagnosis factor included in the first diagnosis result information by using the factor correction model 200. Referring to FIG. 22, the second diagnosis result information is information output from the factor correction model 200 when correction target information is input to the factor correction model 200. The correction target information includes at least one preliminary diagnosis factor and may further include at least one of temperature information and impedance information. The factor correction model 200 may determine at least one precise diagnosis factor by correcting the at least one preliminary diagnosis factor by utilizing at least one of the temperature information and the impedance information as reference information.

The second diagnosis factor group 1220 included in the second diagnosis result information represents the estimated result of the charge/discharge performance that may be determined if the diagnosis logic is applied to the target full-cell profile N instead of the corrected target full-cell profile E.

The target full-cell profile N represents the correspondence between the capacity factor and voltage of the target cell BC during the application period of the second electric stimulation, which is different from the first electric stimulation. The target full-cell profile N may not be obtained by actually applying the second electric stimulation to the target cell BC. That is, the second target full-cell profile N may represent the correspondence between the capacity factor and voltage of the target cell BC, which is expected to be obtained if the second electric stimulation was applied to the target cell BC instead of the first electric stimulation.

Following Step S2450, the control circuit 130 may apply a mathematical operation to the second diagnosis result information to determine at least one degradation parameter of the target cell BC (see Table 1). The control circuit 130 may limit at least one of an allowable voltage range, an allowable SOC range, and an allowable charge/discharging current for the target cell BC based on at least one degradation parameter. The memory 131 may pre-store relationship data indicating the correspondence between the at least one limitation item (i.e., the allowable voltage range, the allowable SOC range, and/or the allowable charge/discharging current) and the at least one degradation parameter. For example, as the increase amount of a specific type of degradation parameter (e.g., $P_{LOSS}$, $N_{LOSS}$, $L_{LOSS}$, $F_{LOSS}$) from the BOL state is larger and/or as the decrease amount of another type of degradation parameter (e.g., $P_{SOH}$, $N_{SOH}$, $L_{SOH}$, $F_{SOH}$) from the BOL state is larger, the limitation amount for the allowable voltage range, the allowable SOC range, and/or the allowable charge/discharging current may be greater.

Meanwhile, if the amount of the training data set used for training the factor correction model 200 is insufficient, the correction performance of the factor correction model 200 may be poor. If the correction performance of the factor correction model 200 is low, the second diagnosis factor group output from the factor correction model 200 may not properly represent the actual charge/discharge performance of the target cell BC.

In addition, if the aforementioned degradation parameters are determined based on output data from the factor correction model 200 whose correction performance is lower than a certain level, incorrect control may be executed for the allowable voltage range, the allowable SOC range, and/or the allowable current range of the target cell BC. As a result, the degradation of the life of the target cell BC may be accelerated, or it may become difficult to fully utilize the charge/-discharge performance of the target cell BC.

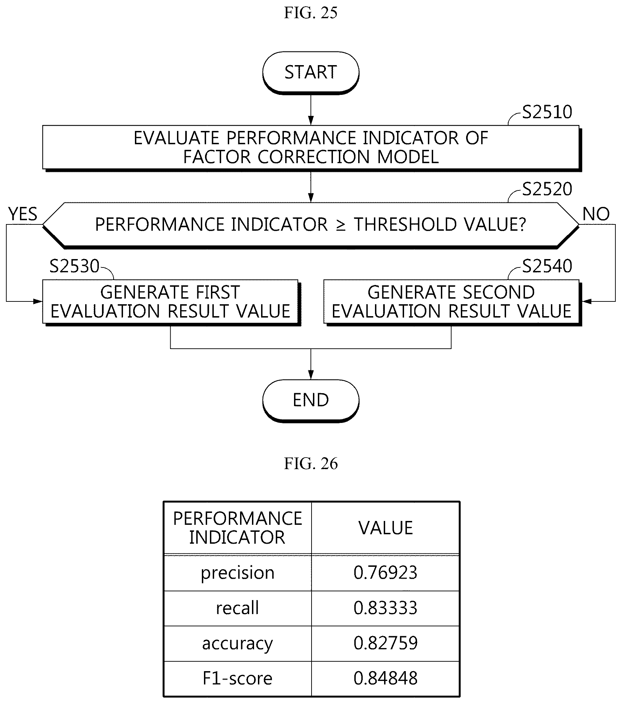

FIG. 25 is a flowchart for schematically illustrating an additional battery diagnosis method related to the battery diagnosis method of FIG. 24, and FIG. 26 is a drawing referenced for explaining the method according to FIG. 25. The method of FIG. 25 is for evaluating the performance of the factor correction model 200 and may be executed by the battery diagnosis apparatus 100 prior to execution of the method according to FIG. 24.

Referring to FIG. 25, in Step S2510, the control circuit 130 evaluates the performance indicator of the factor correction model 200. The evaluation of the performance indicator may be based on an evaluation data set. The evaluation data set may be received from the outside by the data obtaining unit or may be stored in advance in the memory 131. The evaluation data set may include a plurality of first diagnosis factor groups and a plurality of comparison factor groups that are paired in one-to-one relationship with each other. The evaluation data set may be prepared in advance through a method common to the aforementioned method of obtaining the training data set.

The performance evaluation information representing the evaluated performance indicator may represent the classification performance when the factor correction model 200 is used as a classification model. The performance evaluation information may include the value of at least one type of performance indicator.

The control circuit 130 may compare the second diagnosis factor group output from the factor correction model 200 when each first diagnosis factor group of the evaluation data set is input to the factor correction model 200 with each comparison factor group of the evaluation data set related to the input first diagnosis factor group, and determine the difference between them. At this time, two estimated values for the same type of diagnosis factor may be compared with each other. For example, the difference between the value of the first diagnosis factor included in the comparison factor group of the evaluation data set and the value of the first diagnosis factor included in the second diagnosis factor group output from the factor correction model 200 may be determined.

If the difference between two values included in the second diagnosis factor group and the comparison factor group as a diagnosis factor of a specific type is within a predetermined allowable error range, it may be determined that the factor correction model 200 has output a correct answer. Meanwhile, if the difference between the two values is outside the allowable error range, it may be determined that the factor correction model 200 has output an incorrect answer. The allowable error range may be individually determined in advance for each type of diagnosis factor.

FIG. 26 illustrates the performance evaluation information in the form of a data table. Referring to FIG. 26, precision, recall, accuracy, and F1-score, which are widely used for performance evaluation of machine learning models, are illustrated as four performance indicators.

In Step S2520, the control circuit 130 determines whether the performance indicator of the factor correction model 200 is equal to or greater than a threshold value. The threshold value may be individually preset for each performance indicator. For example, if the threshold value for precision is 0.70, the precision illustrated in FIG. 26 is 0.76923, so the value of Step S2520 may be output as "Yes". The value of Step S2520 being "Yes" indicates that each performance indicator of the performance evaluation information is equal to or greater than the threshold value. If the value of Step S2520 is "Yes", the process may proceed to Step S2530. If the value of Step S2520 is "No", the process may proceed to Step S2540.

A performance indicator greater than or equal to the threshold value indicates that the factor correction model 200 has been sufficiently trained to estimate the charge/discharge performance of the target cell BC with a certain level of accuracy or higher. A performance indicator less than the threshold value indicates that the factor correction model 200 has been insufficiently trained.

In Step S2530, the control circuit 130 generates a first evaluation result value. If the first evaluation result value is generated, execution of Step S2450 according to FIG. 24 may be permitted.

In Step S2540, the control circuit 130 generates a second evaluation result value. If the second evaluation result value is generated, the execution of Step S2450 according to FIG. 24 may be prohibited. In addition, the control circuit 130 may transmit a message notifying that additional training for the factor correction model 200 is required to a user device, such as the battery system 1, using the communication circuit 150.

The embodiments of the present disclosure described hereinabove are not implemented only through the apparatus and method, and may be implemented through programs that perform functions corresponding to the configurations of the embodiments of the present disclosure or recording media having the programs recorded thereon, and such implementation may be easily achieved by those skilled in the art from the disclosure of the embodiments previously described.

While the present disclosure has been hereinabove described with regard to a limited number of embodiments and drawings, the present disclosure is not limited thereto and it is obvious to those skilled in the art that various modifications and changes may be made thereto within the technical aspects of the present disclosure and the equivalent scope of the appended claims.

Additionally, as many substitutions, modifications and changes may be made to the present disclosure described hereinabove by those skilled in the art without departing from the technical aspects of the present disclosure, the present disclosure is not limited by the above-described embodiments and the accompanying drawings, and some or all of the embodiments may be selectively combined to allow various modifications.

**Claims**

1. A battery diagnosis method comprising:

   obtaining diagnosis target information including a target full-cell profile of a battery cell associated with a first electric stimulation;
   correcting the target full-cell profile to be associated with a second electric stimulation that is different from the first electric stimulation, based on a predetermined overpotential profile;
   applying a diagnosis logic to the corrected target full-cell profile to determine first diagnosis result information, which is a preliminary diagnosis result for charge/discharge performance of the battery cell; and
   determining second diagnosis result information, which is a precise diagnosis result for the charge/discharge performance of the battery cell, based on at least one preliminary diagnosis factor included in the first diagnosis result information, using a factor correction model.

2. The battery diagnosis method according to claim 1, wherein an instantaneous voltage change induced in the battery cell when the second electric stimulation is applied is smaller than an instantaneous voltage change induced in the battery cell when the first electric stimulation is applied.

3. The battery diagnosis method according to claim 1, wherein the first electric stimulation is a charging current greater than or equal to a first current rate, and
   wherein the second electric stimulation is a charging current less than or equal to a second current rate, which is less than the first current rate.

4. The battery diagnosis method according to claim 1, wherein the first electric stimulation is a discharging current greater than or equal to a first current rate, and
   wherein the second electric stimulation is a discharging current less than or equal to a second current rate, which is less than the first current rate.

5. The battery diagnosis method according to claim 1, wherein the overpotential profile represents a difference between a first reference full-cell profile and a second reference full-cell profile,

   wherein the first reference full-cell profile is predetermined as a correspondence between a capacity factor and a voltage of a reference cell while the first electric stimulation is being applied, and
   wherein the second reference full-cell profile is predetermined as a correspondence between the capacity factor and the voltage of the reference cell while the second electric stimulation is being applied.

6. The battery diagnosis method according to claim 1, wherein the step of correcting the target full-cell profile is to subtract the overpotential profile from the target full-cell profile to generate the corrected target full-cell profile.

7. The battery diagnosis method according to claim 1, wherein the diagnosis target information further includes temperature information of the battery cell measured during an application period of the first electric stimulation, and
   wherein the temperature information is input into the factor correction model together with the at least one preliminary diagnosis factor.

8. The battery diagnosis method according to claim 1, wherein the diagnosis target information further includes impedance information of the battery cell measured during an application period of the first electric stimulation, and
   wherein the impedance information is input into the factor correction model together with the at least one preliminary diagnosis factor.

9. The battery diagnosis method according to claim 1, wherein the factor correction model is a machine learning model completely trained by a training data set that includes a pair of first diagnosis result information and second diagnosis result information of each of a plurality of test cells with different charge/discharge performance.

10. The battery diagnosis method according to claim 9, wherein the first diagnosis result information of each of the plurality of test cells is obtained by applying the diagnosis logic to each of a plurality of corrected test full-cell profiles,

   wherein the plurality of corrected test full-cell profiles are obtained by individually correcting a plurality of first test full-cell profiles associated with the first electric stimulation based on the overpotential profile, and
   wherein the second diagnosis result information of each of the plurality of test cells is obtained by applying the diagnosis logic to a plurality of second test full-cell profiles associated with the second electric stimulation.

11. The battery diagnosis method according to claim 1, wherein the step of determining the second diagnosis result information is performed under the condition that a performance indicator of the factor correction model is evaluated to be greater than or equal to a threshold value.

12. The battery diagnosis method according to claim 11, further comprising:
   transmitting a message to a user device notifying that additional training for the factor correction model is required when the performance indicator of the factor correction model is evaluated to be less than the threshold value.

13. The battery diagnosis method according to claim 1, wherein the second diagnosis result information includes at least one type of diagnosis factor among a positive electrode participation start point, a positive electrode participation end point, and a positive electrode scale factor related to charge/discharge performance of a positive electrode as a precise diagnosis factor of the battery cell.

14. The battery diagnosis method according to claim 1, wherein the second diagnosis result information includes at least one type of diagnosis factor among a negative electrode participation start point, a negative electrode participation end point, and a negative electrode scale factor related to charge/discharge performance of a negative electrode of the battery cell as a precise diagnosis factor of the battery cell.

15. The battery diagnosis method according to claim 1, wherein the second diagnosis result information includes at least one type of diagnosis factor among a positive electrode loading amount related to charge/discharge performance of a positive electrode of the battery cell, a negative electrode loading amount related to charge/discharge performance of a negative electrode of the battery cell, and an NP ratio related to the charge/discharge performance of both the positive electrode and the negative electrode of the battery cell, as a precise diagnosis factor of the battery cell.

16. A battery diagnosis apparatus comprising:

   a data obtaining unit configured to obtain diagnosis target information including a target full-cell profile of a battery cell associated with a first electric stimulation; and
   a control circuit configured to correct the target full-cell profile to be associated with a second electric stimulation that is different from the first electric stimulation, based on a predetermined overpotential profile,
   wherein the control circuit is configured to:

      apply a diagnosis logic to the corrected target full-cell profile to determine first diagnosis result information, which is a preliminary diagnosis result for charge/discharge performance of the battery cell, and
      determine second diagnosis result information, which is a precise diagnosis result for the charge/discharge performance of the battery cell, based on at least one preliminary diagnosis factor included in the first diagnosis result information, using a factor correction model.

17. The battery diagnosis apparatus according to claim 16, wherein the control circuit is configured to subtract the overpotential profile from the target full-cell profile to generate the corrected target full-cell profile.

18. The battery diagnosis apparatus according to claim 16, wherein the factor correction model is a machine learning model completely trained by a training data set that includes a pair of first diagnosis result information and second diagnosis result information of each of a plurality of test cells with different charge/discharge performance.

19. A battery pack comprising the battery diagnosis apparatus according to any one of claims 16 to 18.

20. A battery system comprising the battery diagnosis apparatus according to any one of claims 16 to 18.

FIG. 1

FIG. 2

FIG. 3

FIG. 4

FIG. 5

FIG. 6

FIG. 7

FIG. 8

FIG. 9

FIG. 10

FIG. 11

FIG. 12

**FIRST DIAGNOSIS RESULT INFORMATION**

*1210*

FIRST DIAGNOSIS FACTOR GROUP

POSITIVE ELECTRODE PARTICIPATION START POINT
NEGATIVE ELECTRODE PARTICIPATION START POINT
POSITIVE ELECTRODE PARTICIPATION END POINT
NEGATIVE ELECTRODE PARTICIPATION END POINT
POSITIVE ELECTRODE SCALE FACTOR
NEGATIVE ELECTRODE SCALE FACTOR
POSITIVE ELECTRODE LOADING AMOUNT
NEGATIVE ELECTRODE LOADING AMOUNT
NP RATIO

TEMPERATURE INFORMATION

IMPEDANCE INFORMATION

*200*

FACTOR CORRECTION MODEL

MACHINE LEARNING

**SECOND DIAGNOSIS RESULT INFORMATION**

*1220*

SECOND DIAGNOSIS FACTOR GROUP

POSITIVE ELECTRODE PARTICIPATION START POINT
NEGATIVE ELECTRODE PARTICIPATION START POINT
POSITIVE ELECTRODE PARTICIPATION END POINT
NEGATIVE ELECTRODE PARTICIPATION END POINT
POSITIVE ELECTRODE SCALE FACTOR
NEGATIVE ELECTRODE SCALE FACTOR
POSITIVE ELECTRODE LOADING AMOUNT
NEGATIVE ELECTRODE LOADING AMOUNT
NP RATIO

FIG. 13

FIG. 14

FIG. 15

FIG. 16

FIG. 17

FIG. 18

FIG. 19

FIG. 20

FIG. 21

FIG. 22

FIG. 23

SECOND DIAGNOSIS FACTOR GROUP
= OUTPUT DATA

| | | pi_B[1] | pf_B[2] | ps_B[3] | ni_B[4] | nf_B[5] | ns_B[6] |
|---|---|---|---|---|---|---|---|
| | pi_A[1] | 0.75 | -0.52 | -0.35 | 0.19 | -0.69 | -0.56 |
| | pf_A[2] | 0.24 | 0.66 | 0.48 | 0.11 | 0.43 | 0.32 |
| FIRST DIAGNOSIS FACTOR GROUP | ps_A[3] | 0.69 | 0.22 | 0.55 | -0.34 | -0.42 | -0.66 |
| | ni_A[4] | 0.15 | -0.12 | -0.41 | 0.99 | 0.41 | 0.47 |
| | nf_A[5] | -0.44 | 0.62 | 0.24 | 0.46 | 0.99 | 0.88 |
| | ns_A[6] | 0.21 | -0.32 | -0.57 | 0.89 | 0.17 | 0.33 |
| TEMPERATURE INFORMATION | T_ini | 0.05 | 0.11 | 0.04 | -0.36 | -0.34 | 0.16 |
| | T_end | 0.08 | 0.04 | -0.09 | -0.33 | -0.30 | 0.39 |
| | T_max | 0.10 | 0.15 | -0.02 | -0.02 | -0.04 | 0.55 |
| IMPEDANCE INFORMATION | z_c | -0.03 | -0.63 | -0.20 | -0.40 | -0.59 | -0.43 |
| | z_d | -0.02 | -0.65 | -0.20 | -0.41 | -0.61 | -0.44 |
| | z_temp | -0.01 | -0.65 | -0.22 | -0.41 | -0.61 | -0.43 |

INPUT DATA

FIG. 24

START

S2410

COLLECT MEASUREMENT SIGNAL REPRESENTING MEASUREMENT
VALUES OF VOLTAGE AND CURRENT OF TARGET CELL

S2420

GENERATE TARGET FULL-CELL PROFILE ASSOCIATED WITH
FIRST ELECTRIC STIMULATION

S2430

CORRECT TARGET FULL-CELL PROFILE TO BE
ASSOCIATED WITH SECOND ELECTRIC STIMULATION,
BASED ON OVERPOTENTIAL PROFILE

S2440

DETERMINE FIRST DIAGNOSIS RESULT INFORMATION AS
PRELIMINIARY DIAGNOSIS RESULT BY APPLYING DIAGNOSIS
LOGIC TO CORRECTED TARGET FULL-CELL PROFILE

S2450

DETERMINE SECOND DIAGNOSIS RESULT INFORMATION AS
DIAGNOSIS RESULT BASED ON AT LEAST ONE
PRELIMINIARY DIAGNOSIS FACTOR INCLUDED IN FIRST DIAGNOSIS
RESULT INFORMATION, USING FACTOR CORRECTION MODEL

END

FIG. 25

```
                    ┌─────────┐
                    │  START  │
                    └────┬────┘
                         │                           S2510
        ┌────────────────▼────────────────────────┐
        │   EVALUATE PERFORMANCE INDICATOR OF      │
        │       FACTOR CORRECTION MODEL            │
        └────────────────┬────────────────────────┘
                         │                           S2520
  YES  ╱──────────────────────────────────────────╲  NO
  ◄───┤  PERFORMANCE INDICATOR ≥ THRESHOLD VALUE?  ├───►
       ╲──────────────────────────────────────────╱
   S2530                                        S2540
  ┌──────────────────────┐    ┌──────────────────────┐
  │   GENERATE FIRST     │    │   GENERATE SECOND    │
  │ EVALUATION RESULT VALUE│  │ EVALUATION RESULT VALUE│
  └──────────┬───────────┘    └───────────┬──────────┘
             │                            │
             └──────────────┬─────────────┘
                       ┌─────▼─────┐
                       │    END    │
                       └───────────┘
```

FIG. 26

| PERFORMANCE INDICATOR | VALUE |
|---|---|
| precision | 0.76923 |
| recall | 0.83333 |
| accuracy | 0.82759 |
| F1-score | 0.84848 |

## INTERNATIONAL SEARCH REPORT

| International application No. |
| --- |
| **PCT/KR2024/016662** |

### A. CLASSIFICATION OF SUBJECT MATTER

**G01R 31/367**(2019.01)i; **G01R 31/374**(2019.01)i; **G01R 31/3842**(2019.01)i; **G01R 31/396**(2019.01)i; **G01R 19/165**(2006.01)i; **G01R 19/10**(2006.01)i; **G01R 19/00**(2006.01)i; **G06N 20/00**(2019.01)i; **B60L 58/12**(2019.01)i

According to International Patent Classification (IPC) or to both national classification and IPC

### B. FIELDS SEARCHED

Minimum documentation searched (classification system followed by classification symbols)

G01R 31/367(2019.01); G01R 19/165(2006.01); G01R 31/36(2006.01); G01R 31/374(2019.01); H01M 10/48(2006.01); H02J 7/02(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리 셀(battery cell), 충방전(charge and discharge), 진단 (diagnosis), 과전압 프로파일(overvoltage profile), 풀셀(full cell)

### C. DOCUMENTS CONSIDERED TO BE RELEVANT

| Category* | Citation of document, with indication, where appropriate, of the relevant passages | Relevant to claim No. |
| --- | --- | --- |
| A | KR 10-2023-0036707 A (SAMSUNG ELECTRONICS CO., LTD.) 15 March 2023 (2023-03-15) See paragraphs [0073]-[0121] and figures 1-2 and 9-10. | 1-20 |
| A | KR 10-2008-0000896 A (LG ELECTRONICS INC.) 03 January 2008 (2008-01-03) See paragraphs [0098]-[0111] and figure 4. | 1-20 |
| A | KR 10-2013-0073802 A (SAMSUNG SDI CO., LTD.) 03 July 2013 (2013-07-03) See paragraphs [0045]-[0050]; claim 1 and figure 1. | 1-20 |
| A | KR 10-2015-0049024 A (KOREA LABOR WELFARE CORPORATION CO., LTD.) 08 May 2015 (2015-05-08) See paragraphs [0020]-[0039] and claim 1. | 1-20 |
| A | KR 10-2017-0015293 A (SONY CORPORATION) 08 February 2017 (2017-02-08) See paragraphs [0035]-[0076] and figures 12-15. | 1-20 |

☐ Further documents are listed in the continuation of Box C.      ☑ See patent family annex.

| | |
| --- | --- |
| * Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
| --- | --- |
| **24 February 2025** | **24 February 2025** |

| Name and mailing address of the ISA/KR | Authorized officer |
| --- | --- |
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT
### Information on patent family members

International application No.

**PCT/KR2024/016662**

| Patent document cited in search report | | | Publication date (day/month/year) | Patent family member(s) | | | Publication date (day/month/year) |
|---|---|---|---|---|---|---|---|
| KR | 10-2023-0036707 | A | 15 March 2023 | CN | 101097248 | A | 02 January 2008 |
| | | | | CN | 101097248 | B | 31 October 2012 |
| | | | | EP | 1873541 | A1 | 02 January 2008 |
| | | | | KR | 10-1134894 | B1 | 13 April 2012 |
| | | | | US | 2008-0007221 | A1 | 10 January 2008 |
| | | | | US | 7541775 | B2 | 02 June 2009 |
| KR | 10-2008-0000896 | A | 03 January 2008 | CN | 101097248 | A | 02 January 2008 |
| | | | | CN | 101097248 | B | 31 October 2012 |
| | | | | EP | 1873541 | A1 | 02 January 2008 |
| | | | | KR | 10-1134894 | B1 | 13 April 2012 |
| | | | | US | 2008-0007221 | A1 | 10 January 2008 |
| | | | | US | 7541775 | B2 | 02 June 2009 |
| KR | 10-2013-0073802 | A | 03 July 2013 | CN | 103176136 | A | 26 June 2013 |
| | | | | CN | 103176136 | B | 31 October 2017 |
| | | | | EP | 2607910 | A2 | 26 June 2013 |
| | | | | EP | 2607910 | A3 | 11 December 2013 |
| | | | | EP | 2607910 | B1 | 23 March 2016 |
| | | | | JP | 2013-134250 | A | 08 July 2013 |
| | | | | JP | 6099918 | B2 | 22 March 2017 |
| | | | | KR | 10-1927538 | B1 | 10 December 2018 |
| | | | | US | 2013-0166233 | A1 | 27 June 2013 |
| | | | | US | 9360531 | B2 | 07 June 2016 |
| KR | 10-2015-0049024 | A | 08 May 2015 | None | | | |
| KR | 10-2017-0015293 | A | 08 February 2017 | JP | 2015-230193 | A | 21 December 2015 |
| | | | | KR | 10-2066323 | B1 | 14 January 2020 |
| | | | | US | 10416236 | B2 | 17 September 2019 |
| | | | | US | 2017-0146609 | A1 | 25 May 2017 |
| | | | | WO | 2015-186283 | A1 | 10 December 2015 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020230165769

- KR 1020240065906